# EUROPÄISCHE PATENTSCHRIFT

(11) **EP 1 497 045 B1**
(45) Veröffentlichungstag und Bekanntmachung des Hinweises auf die Patenterteilung: **22.02.2017**
(21) Anmeldenummer: 03746831.1
(22) Anmeldetag: 17.04.2003
(51) Int. Cl.: B05D 3/14

(54) **VERFAHREN UND VORRICHTUNG ZUM HÄRTEN EINER BESCHICHTUNG**
METHOD AND DEVICE FOR HARDENING A COATING
PROCEDE ET DISPOSITIF DE DURCISSEMENT D'UN REVETEMENT

(30) Priorität: 19.04.2002 EP 02008255
(43) Veröffentlichungstag der Anmeldung: 19.01.2005
(73) Patentinhaber: Dürr Systems AG, 74321 Bietigheim-Bissingen (DE)
(72) Erfinder: ORTLIEB, Konrad, 70186 Stuttgart (DE); WIELAND, Dietmar, 70180 Stuttgart (DE); TOBISCH, Wolfgang, 70193 Stuttgart (DE); ROTH, Dietmar, 09353 Oberlungwitz (DE); DITTRICH, Karl-Heinz, 09125 Chemnitz (DE)
(74) Vertreter: Hoeger, Stellrecht & Partner Patentanwälte mbB
(86) Internationale Anmeldenummer: PCT/EP2003/004018
(87) Internationale Veröffentlichungsnummer: WO 2003/089155

(56) Entgegenhaltungen:
- EP-A- 0 361 206
- EP-A- 0 424 873
- EP-A- 1 155 818
- WO-A-01/66824
- WO-A-99/53524
- FR-A- 2 230 831
- US-A- 5 211 995
- US-A- 5 270 267
- US-A- 5 520 741
- US-A- 5 580 606
- US-A- 6 059 434
- US-A- 6 123 991
- US-B1- 6 214 422

## Beschreibung

Die vorliegende Erfindung betrifft ein Verfahren und eine Vorrichtung zum Härten einer, insbesondere strahlungshärtbaren, Beschichtung an einem Werkstück.

Es ist aus dem Stand der Technik bekannt, Werkstücke mit einer Beschichtung aus einem Material zu versehen, welches unter Bestrahlung mit UV-Licht aushärtet, und das so beschichtete Werkstück anschließend mit UV-Strahlung zu beaufschlagen.

Insbesondere ist es bekannt, Werkstücke, beispielsweise Fahrzeugkarosserien, mit einem UV-härtbaren Klarlack zu beschichten und diese Beschichtung durch Bestrahlung des Werkstücks mit UV-Licht auszuhärten.

Solche UV-härtbaren Klarlacke zeichnen sich durch eine besonders hohe Kratzbeständigkeit aus.

Bei den bekannten Verfahren und Vorrichtungen zum Härten von UV-härtbaren Beschichtungen werden die beschichteten Werkstücke mittels aus UV-Lampen stammendem UV-Licht bestrahlt.

Weisen die beschichteten Werkstücke eine komplexe, dreidimensionale Geometrie mit Hinterschneidungen und abgeschatteten Bereichen auf, so ist es erforderlich, die UV-Lampen an Handhabungseinrichtungen einzuordnen, die relativ zu dem Werkstück beweglich sind, damit sämtliche beschichteten Oberflächen des Werkstücks von den UV-Lampen überstrichen werden können. Da die UV-Lampen sperrig sind, kann selbst bei Verwendung solcher Handhabungseinrichtungen nicht jeder Hinterschneidungsbereich oder in sonstiger Weise abgeschatteter Bereich durch das UV-Licht erreicht werden. Die nicht von dem UV-Licht erreichten Bereiche der Beschichtung können nicht aushärten, was dazu führt, dass Bestandteile der nicht ausgehärteten Beschichtung während der Betriebsdauer des Werkstückes ausdünsten und so eine lang andauernde, gesundheitsschädliche Geruchsbelastung entsteht.

Um dieses Problem zu umgehen, ist es bereits bekannt, hybride Lacksysteme zu verwenden, die sowohl durch UV-Strahlung als auch durch Wärmezufuhr ausgehärtet werden können. Ein solches hybrides Lacksystem erlaubt es, die für UV-Lampen gut zugänglichen Bereiche des Werkstücks mittels UV-Strahlung und die schlecht zugänglichen Bereiche des Werkstücks durch Wärmekonvektion auszuhärten. Nachteilig ist, dass zum vollständigen Aushärten eines solchen hybriden Lacksystems zwei völlig verschiedene Verfahrensschritte, nämlich die UV-Bestrahlung und die Härtung durch Wärmekonvektion, nacheinander durchgeführt werden müssen, was einen hohen zeitlichen und einen hohen apparativen Aufwand zur Folge hat, da sowohl die UV-Lampen als auch geeignete Heizeinrichtungen in der Härtungsvorrichtung vorhanden sein müssen.

Die EP 0 424 873 A2 offenbart ein Verfahren zum Modifizieren der Oberfläche eines Werkstücks aus einem Polymermaterial, bei dem das Werkstück aus einem Polymermaterial mit einer Beschichtung aus einem Makromer mit einer radikalisch polymerisierbaren Doppelbindung versehen wird und anschließend einer Hydrophilisierungsbehandlung in einem Plasma unterzogen wird.

Die WO 01/66824 A1 offenbart ein Verfahren zur Plasmapolymerisation, bei dem ein Werkstück zunächst in einer Polymerisierkammer mit einer Polymerbeschichtung versehen wird und diese Polymerbeschichtung anschließend ebenfalls in einem Plasma einer Hydrophilisierungsbehandlung unterworfen wird.

Die US-A-5 520 741 offenbart eine Vorrichtung zur Erzeugung einer Polymer-Schutzschicht auf einem Werkstück, wobei die Vorrichtung einen Plasmaerzeugungsraum, eine Einrichtung zum Einbringen des Werkstücks in den Plasmaerzeugungsraum und eine Einrichtung zum Erzeugen eines Plasmas in dem Plasmaerzeugungsraum umfasst.

Die US-A-5 211 995 offenbart eine Vorrichtung zur Erzeugung einer anorganischen, feuerfesten Beschichtung auf einer Oberfläche eines Werkstücks aus organischem Material, wobei die Vorrichtung einen Plasmaerzeugungsraum und eine Einrichtung zum Erzeugen eines Plasmas in dem Plasmaerzeugungsraum umfasst.

Die US-A-6 123 991 offenbart eine Vorrichtung zum Beschichten von elastomeren Komponenten, wobei die Vorrichtung einen Plasmaerzeugungsraum und eine Einrichtung zum Erzeugen eines Plasmas in dem Plasmaerzeugungsraum umfasst.

Die US 6 059 434 A offenbart ein nicht-planares Werkstück mit einer UV-gehärteten Beschichtung, die an einer Außenseite des Werkstücks angeordnet ist.

Der vorliegenden Erfindung liegt die Aufgabe zugrunde, ein Verfahren zum Härten von strahlungshärtbaren Beschichtungen zu schaffen, welches es ermöglicht, Beschichtungen auch an schwer zugänglichen Bereichen eines dreidimensionalen Werkstücks in einfacher Weise auszuhärten.

Diese Aufgabe wird durch ein Verfahren nach Anspruch 1 gelöst.

Der erfindungsgemäßen Lösung liegt die Erkenntnis zugrunde, dass ein Plasma zum Härten der Beschichtung verwendet werden kann. Dadurch, dass das Werkstück selbst innerhalb des Plasmaerzeugungsraums angeordnet ist und sich das Werkstück innerhalb des erzeugten Plasmas befindet, kann die Beschichtung an allen Oberflächen des Werkstücks, auch an schwer zugänglichen inneren Oberflächen, gehärtet werden.

Dadurch, dass das Werkstück selbst innerhalb des Plasmaerzeugungsraums angeordnet ist und sich das Werkstück innerhalb des erzeugten Plasmas befindet, kann die von dem Plasma emittierte Strahlung von verschiedenen Seiten her zu dem Werkstück gelangen. Insbesondere kann das Plasma auch innerhalb von Hohlräumen des Werkstücks erzeugt werden, so dass die Begrenzungsflächen dieser Hohlräume aus dem Hohlraum selbst mit zum Härten der Beschichtung geeigneter Strahlung beaufschlagt werden. Auf diese Weise kann die zum Härten der Beschichtung geeignete Strahlung an jede beliebige beschichtete Oberfläche des Werkstücks gelangen, insbesondere auch an Hinterschneidungsbereiche oder abgeschattete Bereiche des Werkstücks, so dass die an dem Werkstück vorhandene strahlungshärtbare Beschichtung vollständig ausgehärtet werden kann, ohne dass hierfür komplizierte und aufwendige Handhabungseinrichtungen erforderlich wären.

Vorzugsweise wird die Beschichtung mittels des Plasmas im wesentlichen vollständig gehärtet. In diesem Fall erfordert das erfindungsgemäße Verfahren nur einen einzigen Prozeßschritt, nämlich die Plasmahärtung, so daß das erfindungsgemäße Härtungsverfahren zeitsparend und mit geringem apparativem Aufwand durchgeführt werden kann.

Außerdem reicht es aus, wenn die Beschichtung strahlungshärtbar ist; die Beschichtung muß insbesondere nicht zugleich wärmehärtbar sein, so daß auf komplexe hybride Lacksysteme verzichtet werden kann.

Durch den Verzicht auf die Wärmehärtbarkeit kann für die Beschichtung ein strahlungshärtbares Material verwendet werden, welches eine höhere Qualität, insbesondere eine höhere Kratzbeständigkeit, aufweist.

Da das Plasma bei dem erfindungsgemäßen Verfahren in dem Plasmaerzeugungsraum stets den nicht vom Werkstück eingenommenen Raum einnimmt, hat eine Änderung der Werkstückgeometrie nur geringe oder gar keine Auswirkungen auf den Prozeßverlauf.

Da die Aushärtung der Beschichtung durch Bestrahlung erfolgt und nicht, zumindest nicht ausschließlich, durch Wärmekonvektion, ist es nicht erforderlich, das gesamte Werkstück zum Aushärten der Beschichtung aufzuheizen. Dadurch wird der für die Aushärtung erforderliche Energieaufwand deutlich reduziert.

Vor, während oder nach dem Plasmahärtungsvorgang kann ein separater Wärmehärtungsvorgang, beispielsweise durch Wärmekonvektion und/oder durch Bestrahlung mit infrarotem Licht, vorgesehen sein.

Bei einer bevorzugten Ausgestaltung der Erfindung ist vorgesehen, daß in dem Plasma eine elektromagnetische Strahlung erzeugt wird, die zumindest einen Anteil von UV-Strahlung enthält.

Unter "UV-Strahlung" wird in dieser Beschreibung und den beigefügten Ansprüchen elektromagnetische Strahlung mit einer Wellenlänge im Bereich von 1 nm bis 400 nm verstanden.

Durch geeignete Wahl der Zusammensetzung des Prozeßgases, aus dem das Plasma erzeugt wird, und der Art der Energieeinkopplung in das Plasma sowie des Arbeitsdrucks des Plasmas können der Wellenlängenbereich und die Dosis der im Plasma erzeugten elektromagnetischen Strahlung beeinflußt werden.

Der Anteil extrem kurzwelliger Strahlung mit einer Wellenlänge unterhalb von 100 nm sollte möglichst klein gehalten werden, um eine Schädigung der auszuhärtenden Beschichtung zu vermeiden.

Ferner hat es sich für die Qualität der ausgehärteten Beschichtung als vorteilhaft erwiesen, die Zeitdauer, während derer die Beschichtung der Bestrahlung aus dem Plasma ausgesetzt ist, auf höchstens ungefähr 120 Sekunden, vorzugsweise höchstens ungefähr 90 Sekunden, zu begrenzen.

Vorzugsweise wird das Plasma in der Weise erzeugt, daß das Plasma eine elektromagnetische Strahlung mit einer Wellenlänge im Bereich von ungefähr 50 nm bis ungefähr 850 nm, insbesondere im Bereich von ungefähr 50 nm bis ungefähr 700 nm, vorzugsweise im Bereich von ungefähr 150 nm bis ungefähr 700 nm, besonders bevorzugt im Bereich von ungefähr 200 nm bis ungefähr 600 nm, emittiert.

Besonders günstig ist es, wenn die vom Plasma emittierte Strahlung zumindest einen Anteil von UV-Strahlung, vorzugsweise im Bereich von ungefähr 200 nm bis ungefähr 400 nm, emittiert.

Das Werkstück ist vorteilhafterweise mit einer strahlungshärtbaren Beschichtung versehen, die mit der von dem Plasma emittierten Strahlung ausgehärtet werden kann.

Besonders günstig ist es, wenn das Werkstück mit einer Beschichtung versehen ist, die durch eine elektromagnetische Strahlung, welche zumindest einen Anteil im UV-Bereich umfaßt, vorzugsweise im Bereich von ungefähr 200 nm bis ungefähr 400 nm, härtbar ist.

Als besonders günstig für die Erzeugung eines hohe Dosen von zum Härten der Beschichtung geeigneter Strahlung emittierenden Plasmas hat es sich erwiesen, wenn der Druck in dem Plasmaerzeugungsraum auf einen Wert von höchstens ungefähr 100 Pa, vorzugsweise von höchstens ungefähr 1 Pa, insbesondere von höchstens ungefähr 0,1 Pa, eingestellt wird.

Ferner bietet das Arbeiten bei solch niedrigen Drücken den Vorteil, daß die Aushärtung der Beschichtung im wesentlichen unter Sauerstoffausschluß erfolgt. Da Sauerstoff als Inhibitor für die Vernetzungsreaktion der Beschichtung fungiert, kann die Aushärtung der Beschichtung unter Vakuum schneller ablaufen, und/oder die in das Plasma einzuspeisende Leistung kann im Vergleich zu einer in einer Sauerstoffatmosphäre ablaufenden Vernetzungsreaktion reduziert werden.

Als Prozeßgas, aus dem das Plasma erzeugt wird, sollte ein Gas verwendet werden, das chemisch inert und leicht zu ionisieren ist.

Als besonders günstig hat es sich erwiesen, wenn der Plasmaerzeugungsraum als Prozeßgas Stickstoff und/oder ein Edelgas, vorzugsweise Argon, enthält.

Ferner kann es zur Erhöhung der Ausbeute an nutzbarer Strahlung von Vorteil sein, wenn dem Prozeßgas ein Metall, beispielsweise Quecksilber, oder ein Metallhalogenid, beispielsweise OsF₇ oder IrF₆, zugemischt ist.

Das Plasma kann grundsätzlich dadurch erzeugt werden, daß entweder ein statisches elektrisches Feld an den Plasmaerzeugungsraum angelegt wird, und/oder daß ein elektromagnetisches Wechselfeld in den Plasmaerzeugungsraum eingekoppelt wird.

Vorzugsweise ist vorgesehen, daß das Plasma durch Einkopplung von elektromagnetischer Strahlung in den Plasmaerzeugungsraum mittels mindestens einer Einkopplungseinrichtung erzeugt wird.

Die Frequenz dieser in den Plasmaerzeugungsraum eingekoppelten elektromagnetischen Strahlung kann im Mikrowellenbereich oder im Hochfrequenzbereich liegen.

Dabei wird in dieser Beschreibung und den beigefügten Ansprüchen unter Mikrowellenstrahlung eine elektromagnetische Strahlung mit einer Frequenz im Bereich von 300 MHz bis 300 GHz und unter Hochfrequenzstrahlung eine elektromagnetische Strahlung mit einer Frequenz von 3 kHz bis 300 MHz verstanden.

Als zur Erzeugung hoher Dosen von UV-Strahlung besonders geeignet hat sich die Verwendung von Mikrowellenstrahlung erwiesen.

Bei einer bevorzugten Ausgestaltung der Erfindung ist daher vorgesehen, daß das Plasma durch Einkopplung von Mikrowellenstrahlung, vorzugsweise mit einer Frequenz im Bereich von ungefähr 1 GHz bis ungefähr 10 GHz, insbesondere im Bereich von ungefähr 2 GHz bis ungefähr 3 GHz, erzeugt wird.

Die einzukoppelnde elektromagnetische Strahlung kann insbesondere mittels eines Magnetrons erzeugt werden.

Um die ionisierende Wirkung der eingekoppelten elektromagnetischen Strahlung zu erhöhen, kann vorgesehen sein, daß ein Magnetfeld zur Erzeugung eines ECR ("Electron Cyclotron Resonance")-Effektes erzeugt wird. Hierbei wird, beispielsweise mittels einer Magnetspulenanordnung, ein statisches Magnetfeld erzeugt, welches innerhalb des Plasmaerzeugungsraums im wesentlichen parallel zur Achse des in den Plasmaerzeugungsraums eingekoppelten elektromagnetischen Wechselfeldes ausgerichtet ist. Die Stärke des Magnetfelds wird so eingestellt, daß die Zyklotronfrequenz der Elektronen in dem Magnetfeld der Frequenz der eingekoppelten elektromagnetischen Strahlung entspricht. In diesem Resonanzfall nehmen die freien Elektronen im Plasmaerzeugungsraum besonders viel Energie aus dem elektromagnetischen Wechselfeld auf, was zu einer besonders effizienten Ionisierung des Prozeßgases führt.

Um an verschiedenen Stellen des Plasmas jeweils möglichst hohe Ionendichten erzeugen zu können, kann vorgesehen sein, daß die elektromagnetische Strahlung mittels mehrerer Einkopplungseinrichtungen in den Plasmaerzeugungsraum eingekoppelt wird, wobei die Einkopplungseinrichtungen vorzugsweise auf verschiedenen Seiten relativ zum Werkstück angeordnet sind.

Wenn das zu behandelnde Werkstück einen Hohlraum mit einer Zugangsöffnung aufweist, so wird die elektromagnetische Strahlung vorteilhafterweise mittels mindestens einer Einkopplungseinrichtung so in den Plasmaerzeugungsraum eingekoppelt, daß die elektromagnetische Strahlung durch die Zugangsöffnung in den Hohlraum des Werkstücks gelangt. Dadurch ist gewährleistet, daß auch in dem Hohlraum des Werkstücks ein Plasma mit einer hohen Ionendichte und einer entsprechend hohen UV-Emission erzeugt wird, so daß die Beschichtung an den Begrenzungsflächen des Hohlraums rasch ausgehärtet werden kann.

Wenn es sich bei dem Werkstück um eine Fahrzeugkarosserie handelt, so ist es besonders wichtig, den beim Lackieren der Fahrzeugkarosserie in deren Innenraum hinein gelangenden Lack-Overspray auszuhärten. Dies wird bei dem erfindungsgemäßen Verfahren insbesondere dadurch erleichtert, daß Einkopplungseinrichtungen für elektromagnetische Strahlung den Fensteröffnungen der Fahrzeugkarosserie gegenüberliegend angeordnet sind, und zwar derart, daß die Achse des von der Einkopplungseinrichtung erzeugten Strahlungsfeldes durch die betreffende Fensteröffnung in den Innenraum der Fahrzeugkarosserie hinein weist.

Bei einer bevorzugten Ausgestaltung der Erfindung ist vorgesehen, daß dem Plasmaerzeugungsraum während des Härtungsvorganges ein zu ionisierendes Gas zugeführt wird.

Das zu ionisierende Gas kann insbesondere Stickstoff oder ein Edelgas, beispielsweise Argon, sein.

Durch die kontinuierliche Zufuhr von zu ionisierendem Gas zu dem Plasmaerzeugungsraum während des Härtungsvorganges kann in dem Plasmaerzeugungsraum eine Strömung erzeugt werden, durch welche ionisierte Gasteilchen und/oder durch Stöße mit ionisierten Teilchen angeregte Gasteilchen auch in abgeschattete Bereiche des Werkstücks gelangen können, in welche die eingekoppelte elektromagnetische Strahlung nicht hineingelangt und wo daher kein Plasma gezündet werden kann.

Außerdem wird durch die Erzeugung einer Gasströmung in dem Plasmaerzeugungsraum ein möglichst homogener und isotroper Zustand des Plasmas und somit eine möglichst orts- und richtungsunabhängige Dosis der zur Härtung der Beschichtung geeigneten Strahlung erreicht.

Besonders günstig ist es, wenn das zu ionisierende Gas dem Plasmaerzeugungsraum mittels einer Einspeiseinrichtung zugeführt wird, die einer Einkopplungseinrichtung benachbart ist, mittels welcher eine elektromagnetische Strahlung in den Plasmaerzeugungsraum eingekoppelt wird. Wenn das Gas vor der Verteilung im Plasmaerzeugungsraum möglichst nahe an der Einspeisstelle der elektromagnetischen Strahlung vorbeigeleitet wird, wird in dem eingeleiteten Gas eine besonders hohe Ionendichte erzeugt, die durch die Gasströmung anschließend im gesamten Plasmaerzeugungsraum verteilt wird.

Um das erfindungsgemäße Verfahren besonders zeitsparend durchführen zu können, kann vorgesehen sein, daß das Werkstück vor dem Härtungsvorgang in eine Vorkammer eingebracht, dort einer Vorbehandlung unterzogen wird und für den Härtungsvorgang aus der Vorkammer in den Plasmaerzeugungsraum überführt wird.

Insbesondere kann vorgesehen sein, daß die Vorkammer nach dem Einbringen des Werkstücks evakuiert wird, so daß die Vorkammer in diesem Fall als Einschleuskammer dient, in welcher der Umgebungsdruck des Werkstücks vom Atmosphärendruck auf den Arbeitsdruck des Plasmaerzeugungsraums abgesenkt wird.

Durch die Evakuierung der Vorkammer kommt es zu einem Vorabdampfen von in der Beschichtung enthaltenen Lösemitteln, so daß in der Vorkammer bereits eine Vortrocknung der auszuhärtenden Beschichtung erfolgt.

Alternativ oder ergänzend hierzu kann vorgesehen sein, daß das Werkstück in der Vorkammer mit elektromagnetischer Strahlung, insbesondere mit Mikrowellenstrahlung, beaufschlagt wird. Hierbei kann die auszuhärtende Beschichtung insbesondere durch direkte Absorption der Energie aus der elektromagnetischen Strahlung vorgetrocknet werden. Alternativ oder ergänzend hierzu ist es auch möglich, bereits in der Vorkammer ein Plasma zu zünden, welches zur Härtung der Beschichtung geeignete Strahlung emittiert, um somit bereits einen ersten Härtungsvorgang der Beschichtung zu bewirken.

Ferner kann vorgesehen sein, daß das Werkstück nach dem Härtungsvorgang aus dem Plasmaerzeugungsraum in eine Ausschleuskammer überführt wird.

Insbesondere kann vorgesehen sein, daß die Ausschleuskammer vor dem Überführen des Werkstücks in die Ausschleuskammer auf den Arbeitsdruck des Plasmaerzeugungsraums evakuiert wird.

Nach dem Überführen des Werkstücks in die Ausschleuskammer kann die Ausschleuskammer belüftet, d.h. der Druck in der Ausschleuskammer auf Atmosphärendruck erhöht, werden und anschließend das Werkstück aus der Ausschleuskammer entnommen werden.

Anspruch 21 ist auf ein Werkstück mit einer Beschichtung gerichtet, die nach dem erfindungsgemäßen Verfahren gehärtet worden ist.

Das Werkstück kann jeden beliebigen, insbesondere metallischen und/oder nicht metallischen, Werkstoff umfassen.

Insbesondere kann das Werkstück beispielsweise aus Stahl, Kunststoff oder aus Holz gefertigt sein.

Das erfindungsgemäße Verfahren eignet sich ganz besonders für die Härtung einer Beschichtung an einem Werkstück, das nicht-planar und/oder dreidimensional ausgebildet ist.

Ein nicht-planares Werkstück ist ein Werkstück, dessen beschichtete Flächen nicht alle in derselben Ebene, sondern in voneinander verschiedenen, insbesondere nicht parallel zueinander ausgerichteten, Ebenen liegen und/oder nicht eben ausgebildet sind.

Insbesondere kann das nicht-planare Werkstück beschichtete Flächen aufweisen, deren Flächennormalen entgegengesetzt zueinander ausgerichtet sind.

Insbesondere ist das erfindungsgemäße Verfahren geeignet für die Härtung einer Beschichtung an einem Werkstück, das mindestens eine beschichtete Hinterschneidung und/oder mindestens einen beschichteten abgeschatteten Bereich aufweist.

Unter einem abgeschatteten Bereich des Werkstücks ist dabei ein solcher Bereich zu verstehen, welcher bei der Beleuchtung des Werkstücks mittels einer punktförmigen oder ebenen Lichtquelle nicht auf direktem Wege von dem von der Lichtquelle ausgehenden Licht erreicht werden würde.

Das erfindungsgemäße Verfahren eignet sich zum Härten einer Beschichtung an einem Werkstück, welches ein elektrisch leitfähiges Material umfaßt und vorzugsweise vollständig aus einem oder mehreren elektrisch leitfähigen Materialien gebildet ist.

Insbesondere kann vorgesehen sein, daß das Werkstück ein metallisches Material umfaßt und vorzugsweise vollständig aus einem oder mehreren metallischen Materialien gebildet ist.

Alternativ oder ergänzend hierzu kann jedoch auch vorgesehen sein, daß das Werkstück ein Kunststoffmaterial und/oder Holz umfaßt und vorzugsweise vollständig aus einem oder mehreren Kunststoffmaterialien bzw. vollständig aus Holz gebildet ist.

Der Plasmaerzeugungsraum kann als Prozeßgas, in dem durch Ionisation ein Plasma erzeugt wird, ein einzelnes Gas oder ein Gemisch mehrerer Gase enthalten.

Als besonders günstig hat es sich erwiesen, wenn der Plasmaerzeugungsraum als Prozeßgas Stickstoff, Helium und/oder Argon enthält.

Argon eignet sich besonders zum Zünden und Stabilisieren des Plasmas.

Helium führt zu einzelnen Intensitäts-Spitzen, insbesondere im langwelligen Bereich des UV-Spektrums.

Stickstoff führt zu mittlerer bis hoher Intensität in einem breiten Bereich des UV-Spektrums.

Insbesondere kann vorgesehen sein, daß der Plasmaerzeugungsraum ein Prozeßgas enthält, dessen Zusammensetzung während des Härtungsvorganges variiert.

So kann beispielsweise vorgesehen sein, daß die Zusammensetzung des Prozeßgases so variiert wird, daß der Schwerpunkt der in dem Plasma während des Härtungsvorgangs erzeugten elektromagnetischen Strahlung während einer ersten Phase des Härtungsvorgangs bei einer ersten Wellenlänge liegt und während einer späteren, zweiten Phase des Härtungsvorgangs bei einer zweiten Wellenlänge liegt, wobei die zweite Wellenlänge von der ersten Wellenlänge verschieden ist.

Besonders günstig ist, wenn die zweite Wellenlänge kleiner ist als die erste Wellenlänge.

Dadurch wird erreicht, daß in der ersten Phase des Härtungsvorgangs elektromagnetische Strahlung mit einem Schwerpunkt im langwelligen Bereich erzeugt wird, welche sich besonders dazu eignet, die Beschichtung an dem Werkstück über ihre gesamte Dicke hinweg durchzuhärten.

Während der zweiten Phase des Härtungsvorgangs wird dann elektromagnetische Strahlung erzeugt, deren Schwerpunkt im kurzwelligen Bereich liegt und welche deshalb insbesondere dazu geeignet ist, die der freien Oberfläche nahe Deckschicht der Beschichtung besonders zu härten.

Bei einer bevorzugten Ausgestaltung des erfindungsgemäßen Verfahrens ist daher vorgesehen, daß die Zusammensetzung des Prozeßgases während des Härtungsvorganges so variiert wird, daß sich der Schwerpunkt der in dem Plasma während des Härtungsvorgangs erzeugten elektromagnetischen Strahlung mit wachsender Härtungsdauer zu kleineren Wellenlängen hin verschiebt.

So kann beispielsweise vorgesehen sein, daß während einer ersten Phase des Härtungsvorgangs von ungefähr 60 Sekunden Dauer in dem Plasmaerzeugungsraum durch entsprechende Steuerung der Gaszufuhr eine Prozeßgaszusammensetzung eingestellt wird, welche ungefähr 20 Volumen-% Argon und im übrigen Helium enthält. Diese Prozeßgaszusammensetzung führt dazu, daß der Schwerpunkt des Spektrums der im Plasma erzeugten elektromagnetischen Strahlung im langwelligen UV-Bereich liegt.

In einer anschließenden, zweiten Phase des Härtungsvorgangs von beispielsweise ungefähr 30 Sekunden Dauer kann diesem Gasgemisch Stickstoff zugegeben werden, um den Schwerpunkt des Spektrums der elektromagnetischen Strahlung, die in dem Plasma erzeugt wird, zu kleineren Wellenlängen hin zu verschieben.

Ferner hat es sich als besonders günstig erwiesen, wenn der Plasmaerzeugungsraum zu dem Zeitpunkt, in dem das Plasma gezündet wird, Argon enthält. Argon ist als Zündgas für die Bildung eines Plasmas und zur Stabilisierung des Plasmas besonders geeignet.

Bei einer besonders bevorzugten Ausgestaltung des erfindungsgemäßen Verfahrens ist daher vorgesehen, daß der Plasmaerzeugungsraum zu dem Zeitpunkt, in dem das Plasma gezündet wird, im wesentlich ausschließlich Argon enthält.

Zur Bildung der gewünschten Prozeßgaszusammensetzung können dem Plasmaerzeugungsraum über eine oder mehrere Einspeiseinrichtungen ein oder mehrere Gase und/oder ein Gasgemisch zugeführt werden.

Um die Strahlungsverteilung in dem Plasmaerzeugungsraum auch an komplexe nicht-planare Werkstückgeometrien anpassen zu können, kann vorgesehen sein, daß das Plasma durch Einkopplung von elektromagnetischer Strahlung in den Plasmaerzeugungsraum mittels mehrerer Einkopplungseinrichtungen erzeugt wird, wobei die Einkopplungseinrichtungen so angeordnet sind, daß bei einer Unterteilung des Plasmaerzeugungsraums in zwei Halbräume mittels einer während des Härtungsvorgangs durch den Schwerpunkt des Werkstücks verlaufenden horizontalen Ebene in jedem der beiden Halbräume mindestens eine Einkopplungseinrichtung vorhanden ist.

Alternativ oder ergänzend hierzu kann auch vorgesehen sein, daß bei einer Unterteilung des Plasmaerzeugungsraums in zwei Halbräume mittels einer während des Härtungsvorgangs durch den Schwerpunkt des Werkstücks verlaufenden vertikalen Ebene in jedem der beiden Halbräume mindestens eine Einkopplungseinrichtung vorhanden ist.

Um die Strahlungsverteilung in dem Plasmaerzeugungsraum möglichst gut an komplizierte nicht-planare Werkstückgeometrien und an räumlich variierende Beschichtungsdicken anpassen zu können, kann vorgesehen sein, daß das Plasma durch Einkopplung von elektromagnetischer Strahlung in den Plasmaerzeugungsraum mittels mehrerer Einkopplungseinrichtungen erzeugt wird, wobei mindestens zwei der Einkopplungseinrichtungen voneinander verschiedene Einkopplungsleistungen aufweisen.

So kann insbesondere vorgesehen sein, daß Einkopplungseinrichtungen mit hoher Einkopplungsleistung in der Nähe von Bereichen des Werkstücks, welche mit einer Beschichtung hoher Dicke versehen sind, angeordnet werden, während Einkopplungseinrichtungen mit geringerer Einkopplungsleistung in der Nähe von Bereichen des Werkstücks angeordnet sein können, welche eine geringere Beschichtungsdicke aufweisen.

Ferner kann vorgesehen sein, daß das Plasma durch Einkopplung von elektromagnetischer Strahlung in den Plasmaerzeugungsraum mittels mehrerer Einkopplungseinrichtungen erzeugt wird, wobei mindestens zwei der Einkopplungseinrichtungen von unterschiedlicher Bauart sind.

So kann beispielsweise eine Einkopplungseinrichtung als eine ECR ("Electron Cyclotron Resonance")-Plasmaquelle und eine andere Einkopplungseinrichtung als eine Hochfrequenz-Parallelplatten-Plasmaanordnung ausgebildet sein.

Um die Strahlungsverteilung in dem Plasmaerzeugungsraum zu homogenisieren und/oder möglichst gut an eine bestimmte Werkstückgeometrie anpassen zu können, kann vorgesehen sein, daß in dem Plasmaerzeugungsraum mindestens ein Reflektor zum Reflektieren der in dem Plasma erzeugten elektromagnetischen Strahlung vorgesehen ist.

Insbesondere kann in dem Plasmaerzeugungsraum mindestens eine Spiegelfolie als Reflektor vorgesehen sein.

Alternativ oder ergänzend hierzu kann vorgesehen sein, daß zumindest ein Teilbereich der Begrenzungswände des Plasmaerzeugungsraums als Reflektor ausgebildet ist.

Als besonders günstig hat es sich erwiesen, wenn der mindestens eine Reflektor als reflektierendes Material Aluminium und/oder Edelstahl umfaßt.

Um den Reflektor in einfacher Weise gegen einen anderen Reflektor anderer Geometrie oder aus einem anderen Material austauschen zu können, ist es von Vorteil, wenn der mindestens eine Reflektor aus dem Plasmaerzeugungsraum entnehmbar ist.

Um in dem Plasmaerzeugungsraum ein gewünschtes Prozeßgas-Strömungsmuster erzeugen zu können, kann vorgesehen sein, daß Gas aus dem Plasmaerzeugungsraum über eine oder mehrere Absaugeinrichtungen abgesaugt wird.

Der Druck in dem Plasmaerzeugungsraum kann in einfacher Weise auch bei konstant gehaltener Gaszufuhr variiert werden, wenn der Druck in dem Plasmaerzeugungsraum mittels mindestens einer Absaugeinrichtung mit einer darin angeordneten Drosselklappe variiert wird.

Je nach Material und Geometrie des beschichteten Werkstücks kann es von Vorteil sein, das Werkstück auf ein von dem elektrischen Potential der Begrenzungswände des Plasmaerzeugungsraums verschiedenes Potential oder auf dasselbe elektrische Potential wie die Begrenzungswände des Plasmaerzeugungsraums zu legen.

Bei einer besonderen Ausgestaltung des erfindungsgemäßen Verfahrens ist vorgesehen, daß das Werkstück mittels einer zumindest teilweise elektrisch isolierenden Halterung elektrisch von den Begrenzungswänden des Plasmaerzeugungsraums getrennt wird.

Durch eine solche Ausgestaltung des Verfahrens wird es möglich, das Werkstück auf ein von dem elektrischen Potential der Begrenzungswände des Plasmaerzeugungsraums verschiedenes elektrisches Potential zu legen.

Alternativ hierzu kann vorgesehen sein, daß das Werkstück mittels einer elektrisch leitfähigen Halterung elektrisch mit den Begrenzungswänden des Plasmaerzeugungsraums verbunden wird.

Hierdurch ist es in einfacher Weise möglich, das Werkstück auf dasselbe elektrische Potential wie die Begrenzungswände des Plasmaerzeugungsraums zu legen.

Ferner kann vorgesehen sein, daß das Werkstück und/oder die Begrenzungswände des Plasmaerzeugungsraums auf Massepotential gelegt werden.

Durch geeignete Wahl des elektrischen Potentials des Werkstücks in Bezug auf die Begrenzungswände des Plasmaerzeugungsraums kann das erzeugte Plasma stabilisiert werden.

Bei einer besonderen Ausgestaltung des erfindungsgemäßen Verfahrens ist ferner vorgesehen, daß das Werkstück mit einer Beschichtung versehen ist, die durch elektromagnetische Strahlung, welche zumindest einen Anteil von UV-Strahlung umfaßt, oder durch Wärme oder durch eine Kombination von elektromagnetischer Strahlung, welche zumindest einen Anteil von UV-Strahlung umfaßt, und Wärme härtbar ist.

Eine solche Beschichtung ist beispielsweise als sogenannter "Dual-Cure-Lack" bekannt.

Durch die Verwendung einer solchen Beschichtung ist es möglich, durch Wärmezufuhr auch diejenigen Stellen der Beschichtung des Werkstücks durchzuhärten, welche von der elektromagnetischen Strahlung, die in dem Plasma erzeugt wird, nicht oder nur in unzureichendem Maße erreicht werden. Die Wärmezufuhr kann dabei beispielsweise durch Infrarot-Strahlung oder durch Konvektion erfolgen. Ferner kann die Wärmezufuhr vor, während und/oder nach der Härtung mittels der im Plasma erzeugten elektromagnetischen Strahlung erfolgen.

Insbesondere zum Zweck einer Vortrocknung oder einer Nachhärtung kann vorgesehen sein, daß das Werkstück vor, während und/oder nach der Erzeugung des Plasmas mit einer elektromagnetischen Strahlung, die nicht in dem Plasma erzeugt wird, beaufschlagt wird.

Eine solche Strahlung kann insbesondere eine Mikrowellenstrahlung und/oder eine Infrarot-Strahlung sein.

Um im Falle lösemittelhaltiger Beschichtungen eine Blasenbildung beim Aushärten der Beschichtung zu vermeiden, kann vorgesehen sein, daß das Werkstück vor, nach und/oder während der Erzeugung des Plasmas getrocknet wird.

Eine solche Trocknung kann beispielsweise durch Bestrahlung der Beschichtung mit Mikrowellenstrahlung und/oder mit Infrarot-Strahlung bewirkt werden.

Alternativ oder ergänzend hierzu kann vorgesehen sein, daß das Werkstück vor der Erzeugung des Plasmas mit einem unterhalb Atmosphärendruck liegenden Druck, vorzugsweise mit einem Druck im Bereich von ungefähr 2000 Pa bis ungefähr 50000 Pa, beaufschlagt wird.

Durch die Beaufschlagung des Werkstücks mit einem solchen erniedrigten Druck kann ein Verdampfen von Lösemittel aus der auszuhärtenden Beschichtung bewirkt werden.

Um den apparativen Aufwand für die Erzeugung eines Vakuums für eine solche Vortrocknung gering zu halten, ist vorzugsweise vorgesehen, daß das Werkstück vor der Erzeugung des Plasmas mit einem unterhalb Atmosphärendruck liegenden Druck beaufschlagt wird, welcher höher ist als der Druck, mit dem das Werkstück während der Erzeugung des Plasmas beaufschlagt wird.

Ferner kann vorgesehen sein, daß während des Härtungsvorgangs in dem Plasmaerzeugungsraum ein Magnetfeld erzeugt wird, welches insbesondere zur Beeinflussung des lokalen Ionisierungsgrads des Plasmas und somit der Strahlungsverteilung in dem Plasmaerzeugungsraum dienen kann.

Dieses zur Beeinflussung der Strahlungsverteilung in dem Plasmaerzeugungsraum dienende Magnetfeld wird unabhängig von und gegebenenfalls zusätzlich zu dem Magnetfeld erzeugt, welches der Ausnutzung des ECR ("Electron Cyclotron Resonance")-Effektes und somit zur Erzeugung des Plasmas dient.

Um den lokalen Ionisierungsgrad und somit die Strahlungsverteilung in dem Plasmaerzeugungsraum während des Härtungsvorgangs verändern zu können, ist bei einer besonderen Ausgestaltung des erfindungsgemäßen Verfahrens vorgesehen, daß die Stärke des zur Beeinflussung der Strahlungsverteilung dienenden Magnetfelds während des Härtungsvorgangs variiert wird.

Insbesondere kann vorgesehen sein, daß das Magnetfeld in dem Plasmaerzeugungsraum erst nach Beginn des Härtungsvorgangs erzeugt wird.

Durch ein solches, erst in einer späteren Phase des Härtungsvorgangs erzeugtes Magnetfeld kann insbesondere die effektive Härtungszeit an Stellen des Werkstücks, die besonders exponiert sind, gegenüber anderen Stellen des Werkstücks verringert werden.

Dies ist besonders günstig, um bei Verwendung eines hellen, insbesondere weißen, Lackes eine Vergilbung zu vermeiden.

Um den lokalen Ionisierungsgrad und damit die Strahlungsverteilung in dem Plasmaerzeugungsraum möglichst gut an die Geometrie des Werkstücks und die lokale Beschichtungsdicke an dem Werkstück anpassen zu können, kann vorgesehen sein, dass die Stärke des zur Beeinflussung der Strahlungsverteilung erzeugten Magnetfelds in dem Plasmaerzeugungsraum räumlich variiert.

Insbesondere bei schweren Werkstücken ist es von Vorteil, wenn eine Fördervorrichtung vorgesehen ist, mittels welcher die Werkstücke in den Plasmaerzeugungsraum hinein und nach dem Härtungsvorgang wieder aus dem Plasmaerzeugungsraum heraus gefördert werden können.

Der vorliegenden Erfindung liegt die weitere Aufgabe zugrunde, eine Vorrichtung zum Härten einer durch elektromagnetische Strahlung härtbaren Beschichtung an einem Werkstück zu schaffen, welche es ermöglicht, Beschichtungen auch an schwer zugänglichen Stellen des Werkstücks in einfacher Weise auszuhärten.

Diese Aufgabe wird durch eine Vorrichtung nach Anspruch 55 gelöst.

Das in dem Plasmaerzeugungsraum erzeugte Plasma emittiert die zum Härten einer strahlungshärtbaren Beschichtung erforderliche Strahlung.

Besondere Ausgestaltungen der erfindungsgemäßen Vorrichtung sind Gegenstand der abhängigen Ansprüche 56 bis 106, deren Vorteile bereits vorstehend im Zusammenhang mit den besonderen Ausgestaltungen des erfindungsgemäßen Verfahrens erläutert worden sind.

Weitere Merkmale und Vorteile der Erfindung sind Gegenstand der nachfolgenden Beschreibung und der zeichnerischen Darstellung von Ausführungsbeispielen.

In den Zeichnungen zeigen:
- Fig. 1: eine schematische Prinzipdarstellung der Härtung einer strahlungshärtbaren Beschichtung an einem Werkstück in einem Plasma;
- Fig. 2: eine schematische Schnittdarstellung einer ersten Ausführungsform einer Vorrichtung zum Härten einer strahlungshärtbaren Beschichtung an einem Werkstück;
- Fig. 3: eine schematische Schnittdarstellung einer zweiten Ausführungsform einer Vorrichtung zum Härten einer strahlungshärtbaren Beschichtung an einem Werkstück;
- Fig. 4: einen schematischen Längsschnitt durch eine dritte Ausführungsform einer Vorrichtung zum Härten einer strahlungshärtbaren Beschichtung, welche zum Härten einer strahlungshärtbaren Beschichtung an Fahrzeugkarosserien dient und eine Einschleuskammer, eine Plasmakammer und eine Ausschleuskammer umfaßt;
- Fig. 5: einen schematischen Querschnitt durch die Vorrichtung aus Fig. 4 längs der Linie 5-5 in Fig. 4;
- Fig. 6 bis 10: schematische Seitenansichten der Vorrichtung aus den Fig. 4 und 15 in aufeinanderfolgenden Phasen eines Arbeitszyklus der Vorrichtung;
- Fig. 11: einen schematischen Längsschnitt durch eine vierte Ausführungsform einer Vorrichtung zum Härten einer strahlungshärtbaren Beschichtung, welche zum Härten einer strahlungshärtbaren Beschichtung an Fahrzeugkarosserien dient und eine Einschleuskammer, eine Plasmakammer und eine Ausschleuskammer umfaßt;
- Fig. 12: einen schematischen Querschnitt durch die Vorrichtung aus Fig. 11 längs der Linie 12-12 in Fig. 11;
- Fig. 13: einen schematischen Querschnitt durch eine fünfte Ausführungsform einer Vorrichtung zum Härten einer strahlungshärtbaren Beschichtung, welche zum Härten einer strahlungshärtbaren Beschichtung an Fahrzeugkarosserien dient und Reflektoren umfaßt;
- Fig. 14: einen schematischen Querschnitt durch eine sechste Ausführungsform einer Vorrichtung zum Härten einer strahlungshärtbaren Beschichtung an einem Werkstück, welche zum Härten einer strahlungshärtbaren Beschichtung an Fahrzeugkarosserien dient und eine Plasmakammer mit reflektierenden Kammerwänden umfaßt;
- Fig. 15: einen schematischen Querschnitt durch eine siebte Ausführungsform einer Vorrichtung zum Härten einer strahlungshärtbaren Beschichtung, welche zum Härten einer strahlungshärtbaren Beschichtung an Fahrzeugkarosserien dient und mehrere Einspeiseinrichtungen und Absaugeinrichtungen für ein Prozeßgas umfaßt;
- Fig. 16: einen schematischen Querschnitt durch eine achte Ausführungsform einer Vorrichtung zum Härten einer strahlungshärtbaren Beschichtung, welche zum Härten einer strahlungshärtbaren Beschichtung an Fahrzeugkarosserien dient und mit einem Magneten zur Beeinflussung des Ionisierungsgrades des erzeugten Plasmas versehen ist;
- Fig. 17: eine ausschnittsweise schematische Seitenansicht einer Fahrzeugkarosserie mit einer strahlungshärtbaren Beschichtung, welche mittels einer Werkstückhalterung an einem Skidrahmen gehalten ist, wobei die Werkstückhalterung einen elektrischen Isolator umfaßt; und
- Fig. 18: eine ausschnittsweise schematische Seitenansicht einer Fahrzeugkarosserie mit einer strahlungshärtbaren Beschichtung, die mittels einer Werkstückhalterung an einem Skidrahmen gehalten ist, wobei die Fahrzeugkarosserie über den Werkstückhalter elektrisch leitend mit dem Skidrahmen verbunden ist.

Gleiche oder funktional äquivalente Elemente sind in allen Figuren mit denselben Bezugszeichen bezeichnet.

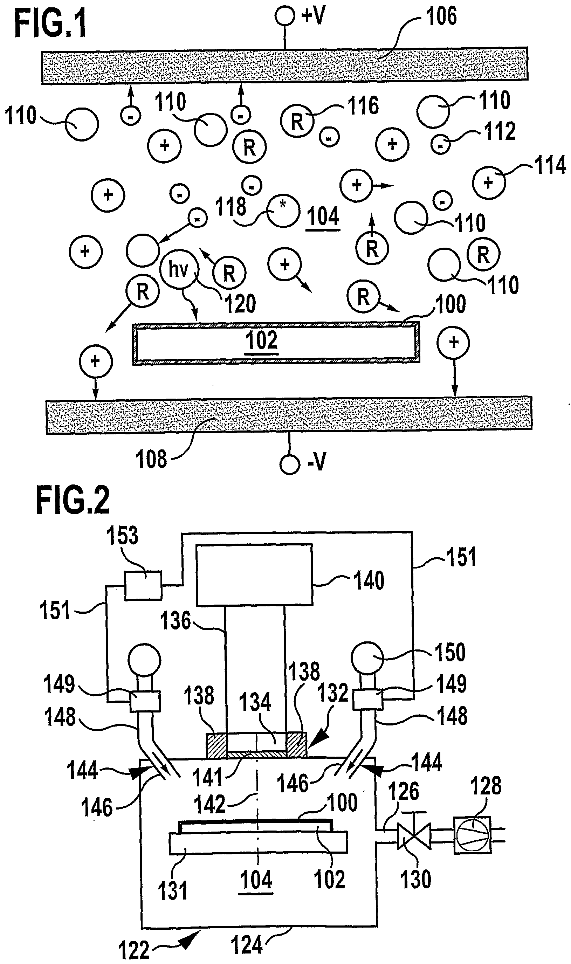

In Fig. 1 ist das Funktionsprinzip eines Verfahrens zur Härtung einer strahlungshärtbaren Beschichtung 100 an einem Werkstück 102, das in einem Plasmaerzeugungsraum 104 angeordnet ist, dargestellt.

Die Beschichtung 100 ist aus einem Material gebildet, welches durch Bestrahlung mit ultravioletter Strahlung aushärtbar ist.

Formulierungen für solche strahlungshärtbaren Materialien sind in der Technik bekannt und vielfach publiziert. So enthalten diese Formulierungen beispielsweise zu polymerisierende Anteile, wie die Monomere, Oligomere und/oder Polymere, gegebenenfalls Bindemittel, einen oder mehrere Photoinitiatoren, und gegebenenfalls weitere übliche Lackzusätze, wie beispielsweise Lösungsmittel, Verlaufshilfsmittel, Adhäsionsverbesserer, Stabilisatoren, z.B. Lichtschutzmittel, UV-Absorber.

Beispiele für geeignete Monomere sind Acrylate, gegebenenfalls Hydroxyl- oder Epoxygruppen enthaltende Acrylate. Als polymerisierbare Komponente können weiterhin ungesättigte, gegebenenfalls funktionalisierte, Amide, Polyester, Polyurethane und Polyether fungieren.

Eine solche strahlungshärtbare Formulierung kann beispielsweise durch Mischen der folgenden Komponenten bereitet werden:
89,0 Teile 75% Epoxyacrylat in Hexandioldiacrylat (welches unter der Bezeichnung ®Ebecryl 604 von der Firma UCB, Belgien, vertrieben wird)
10,0 Teile Polyethylenglykol-400-Diacrylat (welches unter der Bezeichnung ®Sartomer SR 344 von der Firma Sartomer vertrieben wird)
1,0 Teile Silikondiacrylat (welches unter der Bezeichnung ®Ebecryl 350 von der Firma UCB, Belgien, vertrieben wird)
2,0 Teile Phenyl-1-hydroxycyclohexyl-keton (welches unter der Bezeichnung ®Irgacure 184 von der Firma Ciba Spezialitätenchemie, Schweiz, vertrieben wird).

Dieses Material kann durch Bestrahlung mit sichtbarem Licht und mit UV-Licht im Wellenlängenbereich von ungefähr 200 nm bis ungefähr 600 nm vernetzt und somit ausgehärtet werden.

Das Werkstück 102, welches aus einem beliebigen metallischen oder nicht metallischen Material gebildet sein kann, wird in geeigneter Weise, beispielsweise durch Tauchlackieren, durch Spritzlackieren oder durch Besprühen, mit einer Beschichtung aus dem strahlungshärtbaren Material versehen, welche zunächst noch nicht ausgehärtet ist.

Das beschichtete Werkstück 102 wird in den Plasmaerzeugungsraum 104 eingebracht, welches mit einem Prozeßgas, beispielsweise Argon oder Stickstoff, bei einem Arbeitsdruck im Bereich von ungefähr 0,1 Pa bis ungefähr 100 Pa gefüllt ist.

Nachdem das Werkstück 102 in den Plasmaerzeugungsraum 104 eingebracht und in dem Prozeßgas der vorstehend genannte Niederdruck eingestellt worden ist, wird in dem Plasmaerzeugungsraum 104 ein Plasma erzeugt, indem entweder ein statisches elektrisches Feld an den Plasmaerzeugungsraum 104 angelegt wird, wie dies in Fig. 1 durch die Elektroden 106 und 108 schematisch dargestellt ist, und/oder indem ein elektromagnetisches Wechselfeld in den Plasmaerzeugungsraum eingekoppelt wird.

Insbesondere kann vorgesehen sein, daß elektromagnetische Strahlung in den Plasmaerzeugungsraum 104 eingekoppelt wird. Die Frequenz dieser elektromagnetischen Strahlung kann im Mikrowellenbereich (von ungefähr 300 MHz bis ungefähr 300 GHz) oder im Hochfrequenzbereich (von ungefähr 3 kHz bis ungefähr 300 MHz liegen).

Durch Elektronen, die in dem angelegten statischen elektrischen Feld bzw. in dem eingekoppelten elektromagnetischen Wechselfeld Energie aufnehmen, werden die neutralen Teilchen (Atome oder Moleküle) 110 des Prozeßgases stoßionisiert, so daß zusätzliche freie Elektronen 112 und Gasionen 114 entstehen.

Durch Stöße der freien Elektronen 112 und der Gasionen 114 mit weiteren neutralen Gasteilchen entstehen Radikale 116 und angeregte Gasteilchen (Atome oder Moleküle) 118.

Diese angeregten Teilchen des Plasmas emittieren einen Teil der auf sie übertragenen Energie in Form von elektromagnetischer Strahlung 120, welche zumindest zum Teil eine Wellenlänge im sichtbaren Bereich und im UV-Bereich (von ungefähr 200 nm bis ungefähr 600 nm) aufweist.

Ein Teil dieser emittierten UV-Strahlung gelangt aus dem Plasma zu der Beschichtung 100 des innerhalb des Plasmas angeordneten Werkstücks 102, wird dort absorbiert und löst eine Vernetzungsreaktion, beispielsweise eine Polymerisations-, Polykondensations- oder Polyadditionsreaktion, aus, welche zum Aushärten der Beschichtung 100 führt.

Wenn die Beschichtung 100 eine ausreichende Dosis von UV-Strahlung erhalten hat, um eine ausreichende Härtung der Beschichtung 100 zu bewirken, wird die Energiezufuhr zu dem Plasma unterbrochen, so daß wieder eine neutrale Prozeßgas-Atmosphäre entsteht, der Druck in dem Plasmaerzeugungsraum 104 wird auf Atmosphärendruck gebracht, und das Werkstück 102 mit der ausgehärteten Beschichtung 100 wird aus dem Plasmaerzeugungsraum 104 entnommen.

Eine in Fig. 2 schematisch dargestellte, als Ganzes mit 122 bezeichnete Vorrichtung zum Härten einer strahlungshärtbaren Beschichtung 100 an einem Werkstück 102 umfaßt eine gasdichte Plasmakammer 124, deren Innenraum einen Plasmaerzeugungsraum 104 bildet.

Die Plasmakammer 124 kann ein Innenvolumen von beispielsweise ungefähr 100 Litern aufweisen.

Die Plasmakammer 124 ist über eine Absaugleitung 126, die zu einem Vakuum-Pumpsystem 128 führt und mittels eines Sperrventils 130 absperrbar ist, bis auf einen Druck von ungefähr 10⁻³ Pa evakuierbar.

Das an einem Werkstückhalter 131 gehaltene Werkstück 102, das beispielsweise als eine Siliziumscheibe ausgebildet ist, die an ihrer dem Werkstückhalter 131 abgewandten Oberseite mit einer Beschichtung 100 aus dem vorstehend genannten strahlungshärtbaren Material versehen ist, ist über eine (nicht dargestellte) Zugangstüre der Plasmakammer 124 in die in Fig. 2 dargestellte Arbeitsstellung einbringbar.

Mittig über dem in der Arbeitsstellung befindlichen Werkstück 100 ist eine als Ganzes mit 132 bezeichnete Einkopplungseinrichtung für Mikrowellenstrahlung angeordnet, welche eine in einer Hohlleiterstrecke 136 angeordnete Antenne 134 und eine Magnetspulenanordnung 138 umfaßt.

Über die Hohlleiterstrecke 136 ist die Antenne 134 mit einem Magnetron 140 verbunden, das Mikrowellen mit einer Frequenz von beispielsweise 2,45 GHz erzeugt, welche über die Hohlleiterstrecke 136 zu der Antenne 134 gelangen und von dort in den Plasmaerzeugungsraum 104 eingekoppelt werden.

Die Hohlleiterstrecke 136 ist von dem Plasmaerzeugungsraum 104 durch ein Quarzfenster 141 getrennt.

Die Magnetspulenanordnung 138 dient dazu, die ionisierende Wirkung der Mikrowellenstrahlung durch den ECR ("Electron Cyclotron Resonance")-Effekt zu verstärken.

Die Magnetspulenanordnung 138 erzeugt ein statisches Magnetfeld, welches innerhalb des Plasmaerzeugungsraums 104 im wesentlichen parallel zur Achse 142 der von der Antenne 134 ausgesandten Mikrowellenstrahlungskeule ausgerichtet ist. Die Stärke des Magnetfelds wird so eingestellt, daß die Zyklotronfrequenz der Elektronen in dem Magnetfeld der Frequenz der eingestrahlten Mikrowellen entspricht. In diesem Resonanzfall nehmen die freien Elektronen besonders viel Energie aus dem elektromagnetischen Wechselfeld auf, was zu einer besonders effizienten Ionisierung des Prozeßgases führt.

Wird Mikrowellenstrahlung mit einer Frequenz von 2,45 GHz verwendet, so muß ein Magnetfeld mit einer Stärke von 875 Gauss verwendet werden, um den ECR-Effekt zu erzielen.

Symmetrisch zu der Achse 142 der von der Einkopplungseinrichtung 132 erzeugten Mikrowellenstrahlungskeule sind mehrere Einspeiseinrichtungen 144 für Prozeßgas angeordnet, welche jeweils eine abgedichtet in die Plasmakammer 124 geführte Zuführdüse 146 umfassen, die jeweils über eine Zuführleitung 148 mit einem Massenstromregler 149 an ein Gasreservoir 150 angeschlossen ist. Natürlich können auch mehrere Einspeiseinrichtungen 144 an dasselbe Gasreservoir 150 angeschlossen sein.

Jeder der Massenstromregler 149 ist über jeweils eine Steuerleitung 151 an eine Regelungseinheit 153 angeschlossen, welche die Gesamtmenge des dem Plasmaerzeugungsraum 104 zugeführten Prozeßgases in Abhängigkeit von der benötigten Strahlungsmenge regelt.

Als Einkopplungseinrichtung 132 kann insbesondere eine ECR-Plasmaquelle verwendet werden, die unter der Bezeichnung RR 250 von der Firma Roth & Rau Oberflächentechnik AG, D-09337 Hohenstein-Ernstthal, Deutschland, vertrieben wird.

Die vorstehend beschriebene Vorrichtung 122 wird wie folgt betrieben:

Nach dem Einbringen des an dem Werkstückhalter 131 gehaltenen, mit der noch nicht ausgehärteten Beschichtung 100 versehenen Werkstücks 102 in die Plasmakammer 124 wird dieselbe nach Öffnen des Sperrventils 130 mittels des Vakuum-Pumpsystems 128 auf einen Basisdruck von ungefähr 10⁻³ Pa evakuiert.

Anschließend wird Prozeßgas aus den Gasreservoirs 150 über die Einspeiseinrichtungen 144 in den Plasmaerzeugungsraum 104 eingelassen, bis ein Arbeitsdruck von beispielsweise ungefähr 0,3 Pa erreicht ist.

Dabei wird der Gasstrom in die Plasmakammer 124 mittels der Massenstromregler 149 so geregelt, daß der Gasfluß in die Plasmakammer 124 insgesamt ungefähr 10 sccm bis ungefähr 100 sccm (Standardkubikzentimeter pro Minute) beträgt.

Als Prozeßgas wird beispielsweise Argon oder Stickstoff verwendet.

Wenn der gewünschte Arbeitsdruck erreicht ist, wird die von dem Magnetron 140 erzeugte Mikrowellenstrahlung in den Plasmaerzeugungsraum 104 eingekoppelt und damit das Plasma in dem Plasmaerzeugungsraum 104 gezündet.

Die eingekoppelte Mikrowellenleistung beträgt beispielsweise ungefähr 400 Watt bis ungefähr 1000 Watt, vorzugsweise bis ungefähr 600 Watt.

Werden mehrere Einkopplungseinrichtungen 132 verwendet, so beträgt die eingekoppelte Mikrowellenleistung pro Einkopplungseinrichtung vorzugsweise jeweils ungefähr 400 Watt bis ungefähr 1000 Watt, insbesondere bis ungefähr 600 Watt.

Die in die Plasmakammer 124 eingespeisten Gasteilchen werden in der Mikrowellenstrahlungskeule ionisiert und driften von dort weiter durch den Plasmaerzeugungsraum 104, so daß im wesentlichen die gesamte Plasmakammer 124 mit Plasma gefüllt ist.

Durch Stöße der geladenen Teilchen mit den im Plasma angeregten Gasteilchen wird Strahlung im UV-Bereich emittiert, welche von der Beschichtung 100 absorbiert wird und dort die Vernetzungsreaktionen auslöst, welche zum Aushärten der Beschichtung 100 führen.

Nach einer Expositionszeit von beispielsweise 90 Sekunden wird die Plasmabehandlung abgebrochen und die Plasmakammer 124 belüftet.

Das Werkstück 102 mit der ausgehärteten Beschichtung 100 wird entnommen.

Im folgenden werden zwei konkrete Ausführungsbeispiele eines mit der vorstehend beschriebenen Vorrichtung 122 durchgeführten Härtungsverfahrens angegeben:

### Beispiel 1

Es wird eine photohärtbare Formulierung durch Mischen der folgenden Komponenten hergestellt:

| | |
|---|---|
| 44.5 Teile | eines aliphatischen Urethanacrylates (Ebecryl 284; 88 Teile aliphatisches Urethanacrylat/ 12 Teile Hexandioldiacrylat; Bayer AG) |
| 32.2 Teile | eines aliphatischen Urethan-tri/tetra-acrylates (Roskydal UA VP LS 2308; Bayer AG) |
| 50.0 Teile | Isopropanol |
| 1.5 Teile | eines Verlaufhilfsmittels. (Byk 306; Byk Chemie) |

Zu der in der Tabelle angegebenen Formulierung werden 2.7 % 1-Hydroxy-cyclohexyl-phenylketon (Irgacure 184, Ciba Spezialitätenchemie), 0.5 % Bis(2,4,6-trimethylbenzoyl) phenylphosphinoxid (Irgacure 819, Ciba Spezialitätenchemie), 1.5 % Tinuvin 400 (=Mischung aus 2-[4-[(2-Hydroxy-3-dodecyloxypropyl)oxy]-2-hydroxyphenyl]-4,6-bis(2,4-dimethylphenyl)-1,3,5-triazin und 2-[4-[(2-Hydroxy-3-tridecyloxypropyl)oxy]-2-hydroxyphenyl]-4,6-bis(2,4-dimethylphenyl)-1,3,5-triazin, Ciba Spezialiätenchemie) und 1 % Tinuvin 292 (=Mischung aus Bis(1,2,2,6,6-pentamethyl-4-piperidinyl)-sebacate und 1-(Methyl)-8-(1,2,2,6,6-pentamethyl-4-piperidinyl)-sebacate, Ciba Spezialiätenchemie) (bezogen auf Festkörper) gegeben und bei 40°C auf dem Wasserbad gerührt. Ein Coil Coat Aluminium wird in die Form eines auf dem Kopf stehenden U gebracht. Der Lack wird mit Hilfe der Spritzapplikation aufgebracht, so daß eine resultierende Trockenschichtstärke von 30 µm erhalten wird. Der Lack auf dem dreidimensionalen Substrat wird 5 Minuten bei Raumtemperatur, anschließend 10 Minuten bei 80°C in einem Umluftofen abgelüftet und dann in der Plasmakammer 124 gehärtet. Die Härtung erfolgt unter einer N₂/He Atmosphäre mit einem Gasmengenverhältnis von 135/65 sccm, die mit einer Mikrowellen-Antenne eingekoppelte Mikrowellenleistung entspricht 500 W während 90s. Der Abstand der Probe zur Mikrowellen-Antenne beträgt 150 mm. Es wird eine gut gehärtete klebfreie Beschichtung erhalten. Der Grad der Aushärtung wird mit Hilfe der Pendelhärte nach König (DIN 53157) bestimmt. Je höher der Wert für die Pendelhärte ist, desto härter ist die Beschichtung. Die linke Seite des U-förmigen Bleches weist eine Pendelhärte von 67 s, die rechte Seite eine Pendelhärte von 91 s auf. Auf der Oberseite des U-förmigen Bleches erreicht die Pendelhärte den Wert 126 s.

### Beispiel 2

Durch Mischen der folgenden Bestandteile werden Komponenten A und B hergestellt:

**Komponente A**

| | |
|---|---|
| 11.38 Teile | eines hydroxylgruppenhaltigen Polyacrylats; 70 %ig in Butylacetat (Desmophen A 870, Bayer AG) |
| 21.23 Teile | Polyesterpolyol 75 % in Butylacetat (Desmophen VP LS 2089, Bayer AG) |
| 0.55 Teile | eines Verlaufhilfsmittels (Byk 306, Byk Chemie) |
| 32.03 Teile | Methanol |

In die Komponente A werden die folgenden Photoinitiatoren und Lichtschutzmittel eingerührt:

| | |
|---|---|
| 0.17 Teile | Bis(2,4,6-trimethylbenzoyl) phenylphosphinoxid (Irgacure 819, Ciba Spezialitätenchemie) |
| 1.52 Teile | 1-Hydroxy-cyclohexyl-phenylketon (Irgacure 184, Ciba Spezialitätenchemie) |
| 0.85 Teile | Tinuvin 400 (=Mischung aus 2-[4-[(2-Hydroxy-3-dodecyloxypropyl)oxy]-2-hydroxyphenyl]-4,6-bis(2,4-dimethylphenyl)-1,3,5-triazin und 2-[4-[(2-Hydroxy-3-tridecyloxypropyl)oxy]-2-hydroxyphenyl]-4,6-bis(2,4-dimethylphenyl)-1,3,5-triazin, Ciba Spezialiätenchemie) |
| 0.56 Teile | Tinuvin 292 (=Mischung aus Bis(1,2,2,6,6-pentamethyl-4-piperidinyl)-sebacate und 1-(Methyl)-8-(1,2,2,6,6-pentamethyl-4-piperidinyl)-sebacate, Ciba Spezialiätenchemie) |

**Anschliessend wird Komponente B**

| | |
|---|---|
| 32.09 Teile | eines isocyanatgruppenhaltigen Urethanacrylats (Roskydal UA VP LS 2337, Bayer AG) |

zugegeben und homogen verteilt.

Auf diese Weise wird ein Dual-Cure-Lack hergestellt.

Die Applikation des Lacks erfolgt mit einer 100 µm Spaltrakel auf ein planares Coil Coat Aluminium, so daß eine Trockenschichtstärke von 30 µm erhalten wird. Der Lack wird 5 Minuten bei Raumtemperatur abgelüftet, anschliessend während 15 Minuten bei 120°C in einem Umluftofen thermisch vernetzt und dann in der Plasmakammer 124 gehärtet. Die Härtung erfolgt unter einer N₂/Ar Atmosphäre mit einem Gasmengenverhältnis von 160/40 sccm, die Mikrowellenleistung entspricht 800 W während 90 s. Der Abstand der Probe zur Mikrowellen-Antenne beträgt 150 mm. Es wird eine gut gehärtete klebfreie Beschichtung erhalten. Der Grad der Aushärtung wird mit Hilfe der Pendelhärte nach König (DIN 53157) bestimmt. Je höher der Wert für die Pendelhärte ist, desto härter ist die Beschichtung. Es wird ein Wert von 118 s erhalten.

Statt der vorstehend beschriebenen ECR-Plasmaquelle könnte in der Vorrichtung 122 auch eine Hochfrequenz-Parallelplatten-Plasmaanordnung verwendet werden, welche ein Parallelplatten-Elektrodensystem umfaßt, das im Abstand von dem Werkstück in dem Plasmaerzeugungraum angeordnet ist. In diesem Fall wird das Plasma gezündet, indem zwischen die Parallelplatten-Elektrodenanordnung und den Werkstückhalter eine Hochfrequenz-Wechselspannung von beispielsweise ungefähr 13,6 MHz angelegt wird. Die eingespeiste Leistung beträgt beispielsweise ungefähr 10 Watt bis ungefähr 200 Watt. Der bevorzugte Arbeitsdruck beträgt ungefähr 1 Pa und wird durch Einspeisen des zu ionisierenden Gases, vorzugsweise Argon, mittel der Massenstromregler in den Zuführleitungen eingestellt.

Im übrigen stimmt die mit Hochfrequenz betriebene Variante der Vorrichtung hinsichtlich Aufbau und Funktion mit der mit Mikrowellen betriebenen Variante überein, auf deren vorstehende Beschreibung insoweit Bezug genommen wird.

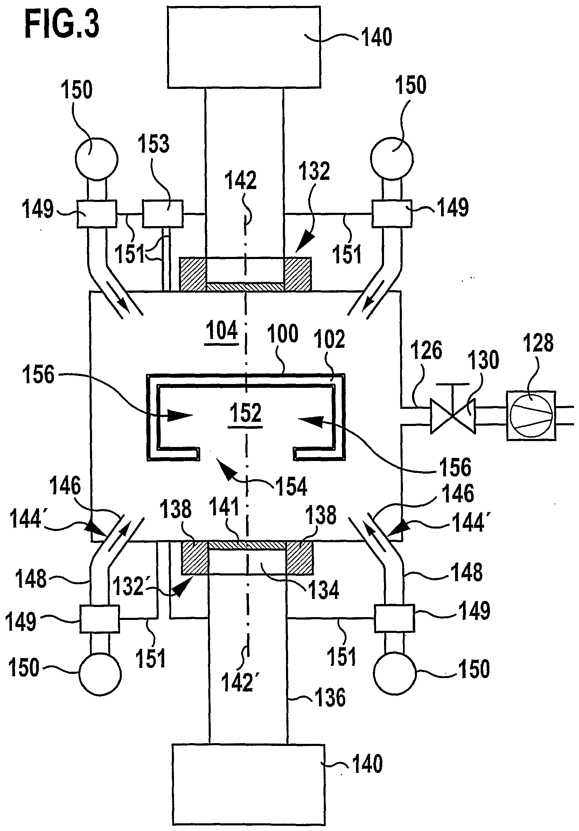

Eine in Fig. 3 schematisch dargestellte zweite Ausführungsform einer Vorrichtung 122 zum Härten einer strahlungshärtbaren Beschichtung 100 an einem Werkstück 102 unterscheidet sich von der vorstehend beschriebenen ersten Ausführungsform dadurch, daß zusätzlich zu der ersten Einkopplungseinrichtung 132 oberhalb der Arbeitsstellung des Werkstücks 102 eine zweite Einkopplungseinrichtung 132' auf der der ersten Einkopplungseinrichtung 132 gegenüberliegenden Seite der Plasmakammer 124 angeordnet ist.

Die zweite Einkopplungseinrichtung 132' entspricht in ihrem Aufbau der ersten Einkopplungseinrichtung 132 und umfaßt insbesondere eine Antenne 134 in einer Hohlleiterstrecke 136, die zu einem Magnetron 140 führt und gegenüber dem Plasmaerzeugungsraum 104 durch eine Quarzglasscheibe 141 abgetrennt ist, sowie eine Magnetspulenanordnung 138 zur Erzeugung des ECR-Effektes.

Ferner sind symmetrisch zu der Achse 142' der von der zweiten Einkopplungseinrichtung 132' erzeugten Mikrowellenstrahlungskeule mehrere Einspeiseinrichtungen 144' für Prozeßgas angeordnet, welche jeweils eine Zuführdüse 146 umfassen, die abgedichtet in den Plasmaerzeugungsraum 104 hineingeführt ist und über eine Zuführleitung 148 mit einem Massenstromregler 149 an ein Gasreservoir 150 angeschlossen ist.

Jeder der Massenstromregler 149 ist über jeweils eine Steuerleitung 151 an die Regelungseinheit 153 angeschlossen, welche die Gesamtmenge des dem Plasmaerzeugungsraum 104 zugeführten Prozeßgases in Abhängigkeit von der benötigten Strahlungsmenge regelt.

Die in Fig. 3 dargestellte zweite Ausführungsform einer Vorrichtung 122 erlaubt es, auch Beschichtungen 100 an komplexer geformten dreidimensionalen Werkstücken 102 auszuhärten, welche beispielsweise, wie das in Fig. 3 gezeigte Werkstück 102, einen Hohlraum 152 mit einer Zugangsöffnung 154 aufweisen, wobei auch die Begrenzungsflächen des Hohlraums mit der auszuhärtenden Beschichtung 100 versehen sind.

Das Werkstück 102 wird in dem Plasmaerzeugungsraum 104 so angeordnet, daß die Zugangsöffnung 154 des Hohlraums 152 der zweiten Einkopplungseinrichtung 132' gegenüberliegt und die Achse 142' der Einkopplungseinrichtung 132' durch die Zugangsöffnung 154 in den Hohlraum 152 hinein weist.

Hierdurch ist gewährleistet, daß die von der zweiten Einkopplungseinrichtung 132' ausgehende Mikrowellenstrahlungskeule in den Hohlraum 152 des Werkstücks 102 hineinreicht, so daß auch im Hohlraum 152 ein Plasma erzeugt wird.

Die durch Stöße mit den geladenen Teilchen des Plasmas angeregten Gasteilchen gelangen durch Diffusion auch in die abgeschatteten Bereiche 156 des Hohlraums 152, in welche keine sichtbare oder UV-Strahlung aus dem außerhalb des Werkstücks 102 liegenden Bereich des Plasmaerzeugungsraums 104 gelangen kann, und emittieren dort sichtbare und UV-Strahlung, welche von der Beschichtung 100 an den Innenwänden der abgeschatteten Bereiche 156 des Hohlraums 152 absorbiert wird. Auf diese Weise kann auch die Beschichtung 100 in diesen abgeschatteten Bereich 156 vollständig ausgehärtet werden.

Im übrigen stimmt die in Fig. 3 dargestellte zweite Ausführungsform einer Vorrichtung 122 zum Härten einer strahlungshärtbaren Beschichtung 100 hinsichtlich Aufbau und Funktion mit der in Fig. 2 dargestellten ersten Ausführungsform überein, auf deren vorstehende Beschreibung insoweit Bezug genommen wird.

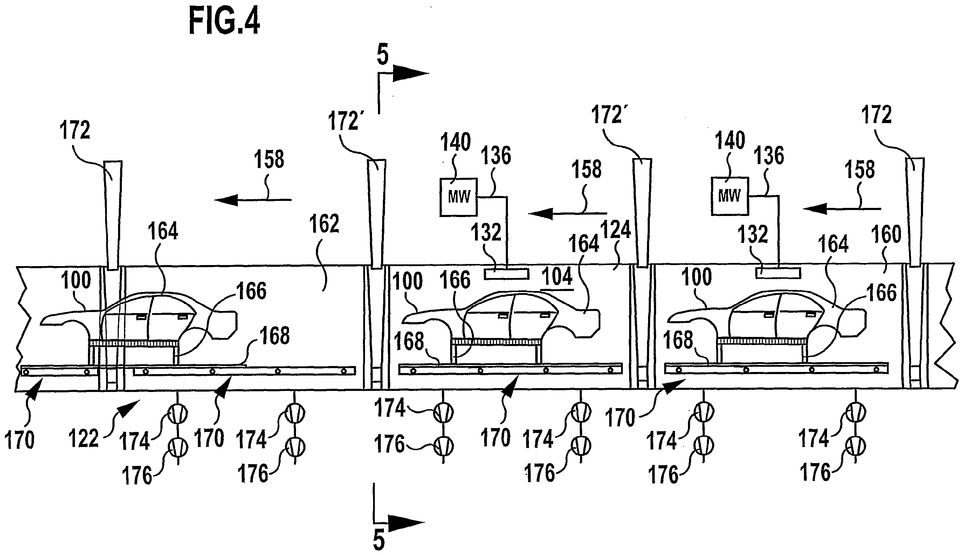

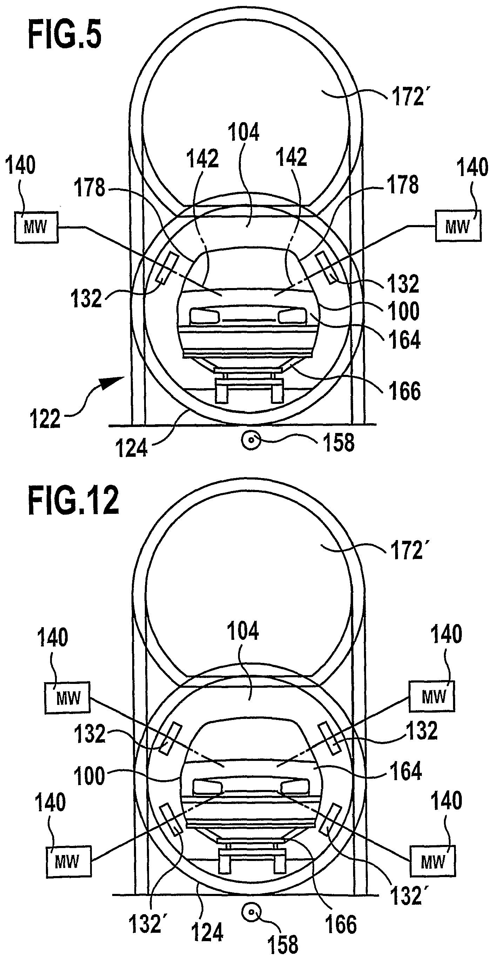

Eine in den Fig. 4 und 5 dargestellte dritte Ausführungsform einer Vorrichtung zum Härten einer strahlungshärtbaren Beschichtung 100 an einem Werkstück 102 umfaßt drei evakuierbare Kammern, die längs einer Förderrichtung 158 aufeinanderfolgen, nämlich eine Vorkammer oder Einschleuskammer 160, eine Plasmakammer 124 und eine Ausschleuskammer 162.

Jede dieser Kammern weist einen Durchmesser von ungefähr 2,5 m und eine Länge von ungefähr 6 m auf, so daß jede Kammer jeweils ein Werkstück in Form einer Fahrzeugkarosserie 164, die auf einem Skidrahmen 166 gehalten ist, aufnehmen kann.

Jeder Skidrahmen umfaßt zwei parallel zur Förderrichtung 158 ausgerichtete Skidkufen 168, mit denen sich der jeweilige Skidrahmen 166 an den Transportrollen von Rollenbahnen 170 abstützen kann, von denen jeweils eine in jeder der Kammern 160, 124 und 162 angeordnet ist.

Der Einlaß der Einschleuskammer 160 und der Auslaß der Ausschleuskammer 162 sind durch jeweils ein vakuumdicht abschließendes äußeres Hubtor 172 verschließbar. Der Durchtritt von der Einschleuskammer 160 in die Plasmakammer 124 und der Durchtritt von der Plasmakammer 124 in die Ausschleuskammer 162 sind durch jeweils ein vakuumdicht abschließendes inneres Hubtor 172' verschließbar.

In den Fig. 4 und 5 sind diese Hubtore 172, 172' in ihrer oberen Offenstellung dargestellt, in welcher die genannten Durchtrittsöffnungen für die Fahrzeugkarosserien 164 geöffnet sind.

Jede der Kammern 160, 124 und 162 ist mittels jeweils einer Vorpumpe 174 und jeweils einer Rootspumpe 176 bis auf einen Arbeitsdruck von ungefähr 1 Pa evakuierbar.

Die Plasmakammer 124 ist mit mehreren Einkopplungseinrichtungen 132 für Mikrowellenstrahlung versehen, von denen eine mittig über der in der Plasmakammer 124 angeordneten Fahrzeugkarosserie 164 angeordnet ist und zwei weitere an den Seitenwänden der Plasmakammer 124 so angeordnet sind, daß sie Fensteröffnungen 178 der Fahrzeugkarosserie 164 gegenüberliegen, so daß die Achsen 142 der von diesen Einkopplungseinrichtungen erzeugten Mikrowellenstrahlungskeulen durch die Fensteröffnungen 178 in den Innenraum der Fahrzeugkarosserie 164 hineinweisen.

Jede der Einkopplungseinrichtungen 132 ist über jeweils eine Hohlleiterstrecke 136 mit einem Magnetron 140 zur Erzeugung von Mikrowellen mit einer Frequenz von 2,45 GHz verbunden.

Ferner sind benachbart zu jeder der Einkopplungseinrichtungen 132 (nicht dargestellte) Gasduschen angeordnet, welche über Zuführleitungen mit Gasreservoirs verbunden sind und durch welche ein Prozeßgas, beispielsweise Strickstoff oder Argon, während des Härtungsvorgangs in die Plasmakammer 124 einspeisbar ist.

Auch in der Einschleuskammer 160 ist eine Einkopplungseinrichtung 132 für Mikrowellenstrahlung vorgesehen, die über eine Hohlleiterstrecke 136 mit einem Magnetron 140 verbunden und mittig über der in der Einschleuskammer 160 angeordneten Fahrzeugkarosserie 164 angeordnet ist.

Die Einkopplungseinrichtungen 132 sind innerhalb der Plasmakammer 124 bzw. innerhalb der Einschleuskammer 160 verschiebbar, um sie in Abhängigkeit von der Geometrie der Fahrzeugkarosserie 164 optimal positionieren, insbesondere möglichst nah an die Fensteröffnungen heranbringen, zu können.

Die vorstehend beschriebene Vorrichtung 122 zum Härten von strahlungshärtbaren Beschichtungen an Fahrzeugkarosserien 164 funktioniert wie folgt:

Die Vorrichtung wird taktweise betrieben, wobei jeweils ein erster Arbeitstakt, ein erster Transporttakt, ein zweiter Arbeitstakt und ein zweiter Transporttakt aufeinanderfolgen und einen Arbeitszyklus der Vorrichtung bilden.

Die gesamte Zykluszeit, das heißt die Summe der Dauer beider Arbeitstakte und beider Transporttakte, beträgt ungefähr 90 Sekunden.

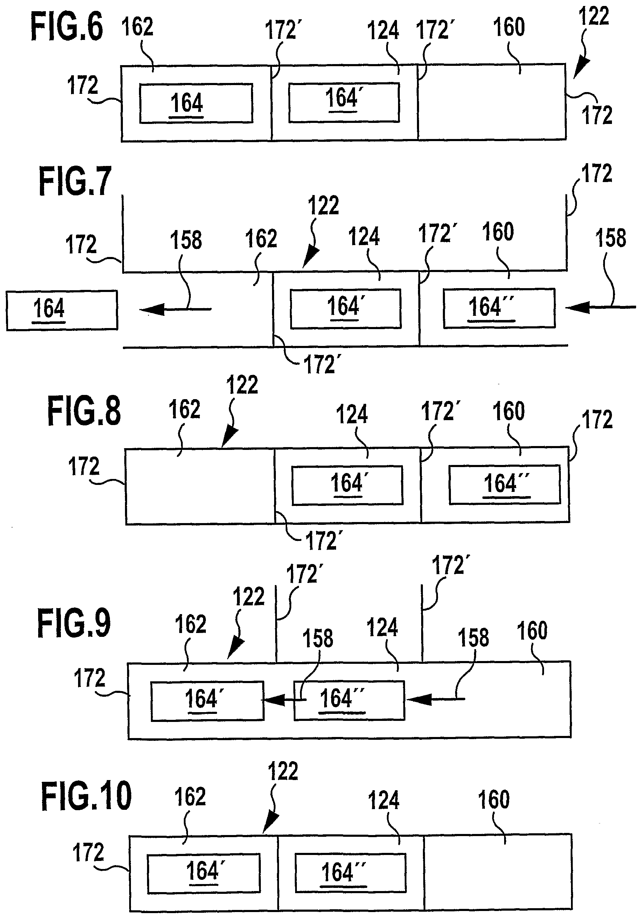

Während des schematisch in Fig. 6 dargestellten ersten Arbeitstaktes sind alle Hubtore 172, 172' geschlossen. In der Ausschleuskammer 162 ist eine Fahrzeugkarosserie 164 und in der Plasmakammer 124 ist eine weitere Fahrzeugkarosserie 164' angeordnet.

Im ersten Arbeitstakt wird die Ausschleuskammer 162 belüftet, bis in derselben der Umgebungsdruck erreicht ist.

Die Fahrzeugkarosserie 164' in der Plasmakammer 124 wird in dem ersten Arbeitstakt einem Plasmahärtungsvorgang unterzogen, in dem über die Gasduschen das Prozeßgas in den als Plasmaerzeugungsraum 104 dienenden Innenraum der Plasmakammer 124 eingespeist und das Plasma mittels der Mikrowellenstrahlung von den Magnetrons 140 gezündet wird.

Diejenigen Bereiche der Beschichtung 100 der Fahrzeugkarosserie 164', welche direkt an einen Bereich des Plasmaerzeugungsraums 104 angrenzen, in dem Plasma gezündet hat, werden aus diesem Bereich mit sichtbarer Strahlung und UV-Strahlung bestrahlt.

Ferner diffundieren durch Stöße mit geladenen Teilchen des Plasmas angeregte Gasteilchen auch in die abgeschatteten Bereiche im Innenraum der Fahrzeugkarosserie 164' hinein und emittieren dort sichtbares Licht und UV-Licht, so daß die Beschichtung 100 auch in diesen abgeschatteten Bereichen 156 ausgehärtet wird.

Die in die Plasmakammer 124 während des Härtungsvorgangs eingespeiste Mikrowellenleistung beträgt insgesamt ungefähr 10 kW.

Die leere Einschleuskammer 160 wird während des ersten Arbeitstaktes belüftet, bis in derselben der Umgebungsdruck erreicht ist.

Im auf den ersten Arbeitstakt folgenden, in Fig. 7 dargestellten ersten Transporttakt werden die äußeren Hubtore 172 geöffnet. Anschließend wird eine neue Fahrzeugkarosserie 164" aus dem in der Förderrichtung 158 vor der Einschleuskammer 160 liegenden Bereich einer Lackieranlage, in welchem die Fahrzeugkarosserie 164" mit einer Lackierung aus strahlungshärtbarem Material, das beispielsweise die vorstehend genannte Zusammensetzung aufweist, versehen worden ist, in die Einschleuskammer 160 gefördert, während die im ersten Arbeitstakt in der Ausschleuskammer 162 befindliche Fahrzeugkarosserie 164 mittels der Rollenbahn 170 in der Ausschleuskammer 162 in den auf die Ausschleuskammer 162 folgenden Bereich der Lackieranlage weitergefördert wird.

Die Fahrzeugkarosserie 164' verbleibt während des ersten Transporttaktes in der Plasmakammer 124, wobei der Plasmahärtungsvorgang während des ersten Transporttaktes fortgesetzt wird.

An den ersten Transporttakt schließt sich der in Fig. 8 dargestellte zweite Arbeitstakt der Vorrichtung an, in dem wieder alle Hubtore 172, 172' geschlossen sind.

In dem zweiten Arbeitstakt wird der Plasmahärtungsvorgang an der Fahrzeugkarosserie 164' in der Plasmakammer 124 fortgesetzt.

Ferner werden während des zweiten Arbeitstaktes die Einschleuskammer 160 und die Ausschleuskammer 162 mittels der jeweiligen Vorpumpe 174 und der jeweiligen Rootspumpe 176 von Atmosphärendruck auf einen Arbeitsdruck von ungefähr 100 Pa evakuiert. Durch diese Evakuierung kommt es zu einer Vortrocknung der an der Fahrzeugkarosserie 164" in der Einschleuskammer 160 in Form der Lackierung vorhandenen Beschichtung 100.

Mittels der Einkopplungseinrichtung 132 kann ferner Mikrowellenstrahlung vom Magnetron 140 in die Einschleuskammer 160 eingekoppelt werden, um die Beschichtung 100 direkt durch Mikrowellenstrahlung zu trocknen oder, falls gewünscht, bereits in der Einschleuskammer 160 ein Plasma zu zünden, welche sichtbare Strahlung und UV-Strahlung in die Beschichtung emittiert und somit einen ersten Härtungsvorgang der Beschichtung bewirkt.

Nach Ende der vorgesehenen Expositionszeit der Fahrzeugkarosserie 164' in der Plasmakammer von beispielsweise ungefähr 60 Sekunden wird die Energiezufuhr zu dem Plasma unterbrochen und die Gaszufuhr eingestellt.

In dem sich an den zweiten Arbeitstakt anschließenden, in Fig. 9 dargestellten zweiten Transporttakt werden die inneren Hubtore 172' geöffnet, während die äußeren Hubtore 172 geschlossen bleiben.

Im zweiten Transporttakt wird die Fahrzeugkarosserie 164' aus der Plasmakammer 124 mittels der Rollenbahnen in der Plasmakammer 124 und in der Ausschleuskammer 162 in die Ausschleuskammer 162 gefördert.

Gleichzeitig wird im zweiten Transporttakt die Fahrzeugkarosserie 164" aus der Einschleuskammer 160 mittels der Rollenbahnen in der Einschleuskammer 160 und in der Plasmakammer 124 in die Plasmakammer 124 gefördert.

Anschließend werden die inneren Hubtore 172' geschlossen und der Arbeitszyklus der Vorrichtung 122 beginnt wiederum mit einem ersten Arbeitstakt (Fig. 10), in welchem die Fahrzeugkarosserie 164" in der Plasmakammer 124 einem Plasmahärtungsvorgang unterzogen und die Ausschleuskammer 162 sowie die Einschleuskammer 160 wieder belüftet werden, bis in denselben der Umgebungsdruck erreicht ist.

Ergänzend zu der Plasmahärtung in der Plasmakammer 124 kann auch vorgesehen sein, daß die Fahrzeugkarosserien in der Einschleuskammer 160 thermisch vorbehandelt und/oder in der Ausschleuskammer 162 thermisch nachbehandelt werden.

Die thermische Vor- bzw. Nachbehandlung kann insbesondere einen separaten Wärmehärtungsvorgang umfassen, bei dem die Lackierung durch Wärmezufuhr, beispielsweise mittels Wärmekonvektion und/oder durch Bestrahlung mit infrarotem Licht, auf eine Temperatur im Bereich von beispielsweise ungefähr 50°C bis ungefähr 250°C erwärmt und so gehärtet wird.

Ferner können die Fahrzeugkarosserien auch in der Plasmakammer 124 vor, während und/oder nach dem Plasmahärtungsvorgang thermisch behandelt werden, beispielsweise durch Erwärmung der Lackierung mittels Bestrahlung mit infrarotem Licht.

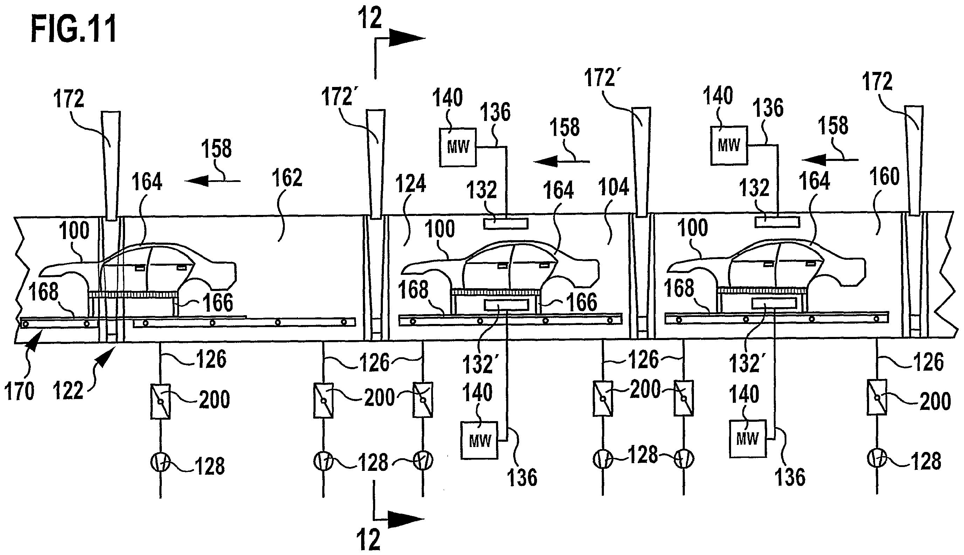

Eine in den Fig. 11 und 12 dargestellte vierte Ausführungsform einer Vorrichtung zum Härten einer strahlungshärtbaren Beschichtung 100 an einem Werkstück 102 unterscheidet sich von der in den Fig. 4 und 5 dargestellten dritten Ausführungsform dadurch, daß zusätzlich zu den Einkopplungseinrichtungen 132 für Mikrowellenstrahlung, welche oberhalb der horizontalen Längsmittelebene der Fahrzeugkarosserien 164 mit der strahlungshärtbaren Beschichtung 100 angeordnet sind, zusätzliche Einkopplungseinrichtungen 132' vorgesehen sind, welche unterhalb der horizontalen Längsmittelebene der Fahrzeugkarosserien 164 angeordnet sind, was am besten aus Fig. 12 zu ersehen ist.

Auch jede dieser zusätzlichen Einkopplungseinrichtungen 132' ist über jeweils eine Hohlleiterstrecke 136 mit einem Magnetron 140 zur Erzeugung von Mikrowellen mit einer Frequenz von 2,45 GHz verbunden.

Die verschiedenen Einkopplungseinrichtungen 132, 132' können alle von derselben Bauart sein.

Alternativ hierzu ist es aber auch möglich, vorzusehen, daß sich mindestens zwei dieser Einkopplungseinrichtungen 132, 132' hinsichtlich ihrer Bauart und/oder hinsichtlich der in den Plasmaerzeugungsraum 104 eingekoppelten Mikrowellenleistung unterscheiden.

Insbesondere kann vorgesehen sein, daß eine Einkopplungseinrichtung 132 oder 132', welche sich in der Nähe eines Bereichs der Fahrzeugkarosserie 164 befindet, in welchem die Dicke der Beschichtung 100 vergleichsweise hoch ist, eine höhere Einkopplungsleistung aufweist als eine Einkopplungseinrichtung 132 oder 132', die sich in der Nähe eines Bereichs der Fahrzeugkarosserie 164 befindet, in welchem die Dicke der Beschichtung 100 niedriger ist.

Ferner ist bei dieser vierten Ausführungsform in den Absaugleitungen 126 zwischen der Plasmakammer 124, der Einschleuskammer 160 und der Ausschleuskammer 162 einerseits und den Vakuumpumpen 128, mittels welcher die jeweilige Kammer 124 evakuierbar ist, andererseits jeweils eine Drosselklappe 200 vorgesehen.

Durch die saugseitig angeordneten Drosselklappen 200 kann der Druck in der Plasmakammer 124 bzw. in der Einschleuskammer 160 oder der Ausschleuskammer 162 auch bei konstanter Gaszufuhr zu der betreffenden Kammer variiert werden. Auf diese Weise kann in jeder der Kammern ein gewünschtes, zeitlich variierendes Druckprofil erzeugt werden, ohne daß hierfür eine Steuerung oder Regelung der Gaszufuhr zu der jeweiligen Kammer erforderlich ist.

Durch die Erhöhung der Anzahl der Einkopplungseinrichtungen 132, 132' und/oder durch die an die jeweilige örtliche Beschichtungsdicke angepaßte Einkopplungsleistung der Einkopplungseinrichtungen 132, 132' kann eine Vergleichmäßigung des Zustands des Plasmas in der Plasmakammer 124 erzielt werden.

Im übrigen stimmt die vierte Ausführungsform einer Vorrichtung zum Härten einer strahlungshärtbaren Beschichtung hinsichtlich Aufbau und Funktion mit der dritten Ausführungsform überein, auf deren vorstehende Beschreibung insoweit Bezug genommen wird.

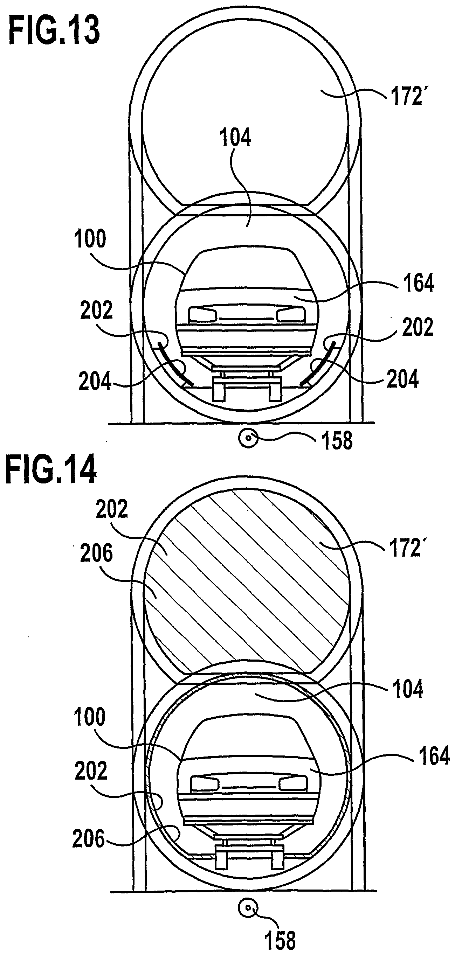

Eine in Fig. 13 dargestellte fünfte Ausführungsform einer Vorrichtung zum Härten einer strahlungshärtbaren Beschichtung 100 an einem Werkstück 102 unterscheidet sich von der vorstehend beschriebenen dritten Ausführungsform lediglich dadurch, daß innerhalb der Plasmakammer 124 Reflektoren 202 mit jeweils einer den Fahrzeugkarosserien 164 zugewandten Reflektionsfläche 204 vorgesehen sind.

Die Reflektoren 202 dienen dazu, die im Plasma erzeugte elektromagnetische Strahlung zu den Fahrzeugkarosserien 164 hin zu reflektieren und somit eine Homogenisierung der Strahlungsverteilung in der Plasmakammer 124 zu erzielen.

Außerdem ist es mittels der Reflektoren 202 möglich, auch schwer zugängliche, abgeschattete Bereiche der Fahrzeugkarosserien 164 mit einer ausreichenden Menge von elektromagnetischer Strahlung zu beaufschlagen.

Die Reflektionsflächen 204 können beispielsweise aus Aluminium oder aus Edelstahl gebildet oder mit einer Spiegelfolie aus einem dieser Materialien versehen sein.

Vorzugsweise sind die Reflektoren 202 lösbar an den Wänden der Plasmakammer 124 gehalten, so daß die Reflektoren 202 aus der Plasmakammer 124 entnommen und gegen andere Reflektoren 202 ausgetauscht werden können.

Im übrigen stimmt die fünfte Ausführungsform einer Vorrichtung zum Härten einer Beschichtung an einem Werkstück hinsichtlich Aufbau und Funktion mit der dritten Ausführungsform überein, auf deren vorstehende Beschreibung insoweit Bezug genommen wird.

Eine in Fig. 14 dargestellte sechste Ausführungsform einer Vorrichtung zum Härten einer strahlungshärtbaren Beschichtung an Fahrzeugkarosserien 164 unterscheidet sich von der vorstehend beschriebenen fünften Ausführungsform dadurch, daß die Begrenzungswände der Plasmakammer 124 (einschließlich der dem Innenraum der Plasmakammer 124 zugewandten Wandflächen der inneren Hubtore 172') mit einer reflektierenden Beschichtung 206 versehen sind, so daß bei dieser Ausführungsform die Begrenzungswände der Plasmakammer 124 selbst als Reflektoren 202 dienen, welche in dem Plasmaerzeugungsraum 104 erzeugte elektromagnetische Strahlung zu dem Werkstück 102 hin reflektieren.

Die reflektierenden Beschichtungen 206 können beispielsweise aus Aluminium oder aus Edelstahl gebildet sein.

Ferner kann vorgesehen sein, daß die Begrenzungswände der Plasmakammer 172 nicht mit einer reflektierenden Beschichtung versehen, sondern insgesamt aus einem reflektierenden Material gebildet sind.

Die separat von den Begrenzungswänden der Plasmakammer 124 vorgesehenen Reflektoren der fünften Ausführungsform können bei der sechsten Ausführungsform entfallen. Es wäre aber auch denkbar, zusätzliche Reflektoren 202, wie sie im Zusammenhang mit der fünften Ausführungsform beschrieben worden sind, innerhalb der Plasmakammer 124 mit den reflektierenden Begrenzungswänden anzuordnen, um die Strahlungsverteilung in der Plasmakammer 124 bei Bedarf gezielt zu beeinflussen.

Im übrigen stimmt die sechste Ausführungsform einer Vorrichtung zum Härten einer strahlungshärtbaren Beschichtung hinsichtlich Aufbau und Funktion mit der fünften Ausführungsform überein, auf deren vorstehende Beschreibung insoweit Bezug genommen wird.

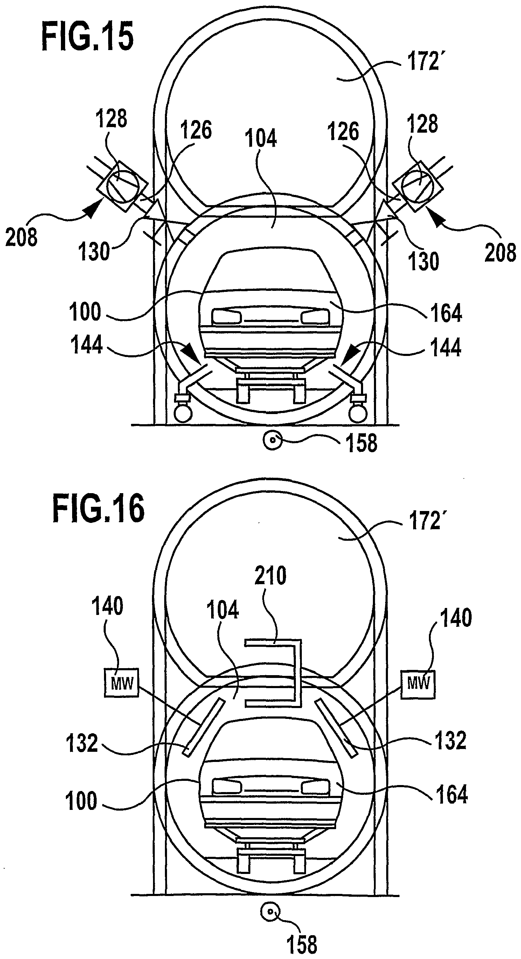

Eine in Fig. 15 dargestellte siebte Ausführungsform einer Vorrichtung zum Härten einer strahlungshärtbaren Beschichtung 100 an einem Werkstück 102 weist mehrere Einspeiseinrichtungen 144 zum Zuführen von Prozeßgas zu der Plasmakammer 124 und mehrere Absaugeinrichtungen 208 zum Absaugen von Gas aus der Plasmakammer 124 auf.

Jede der Absaugeinrichtungen 208 umfaßt eine Absaugleitung 126, in welcher ein Sperrventil 130 und eine Vakuumpumpe 128 angeordnet sind.

Wie aus Fig. 15 zu ersehen sind, sind die Einspeiseinrichtungen 144 im Bereich unterhalb der horizontalen Längsmittelebene der Fahrzeugkarosserien 164 und die Absaugeinrichtungen 208 im Bereich oberhalb der horizontalen Längsmittelebene der Fahrzeugkarosserien 164 angeordnet.

Auf diese Weise kann eine definierte Strömung des Prozeßgases, in dem das Plasma erzeugt wird, von unten nach oben durch die Plasmakammer 124 und insbesondere durch die Fahrzeugkarosserien 164 hindurch erzeugt werden.

Die Erzeugung einer solchen definierten Strömung des Prozeßgases durch die Plasmakammer 124 hat sich als günstig für die Erzeugung eines stabilen Plasmas mit einer gleichmäßigen Strahlungsverteilung erwiesen.

Im übrigen stimmt die siebte Ausführungsform einer Vorrichtung zum Härten einer strahlungshärtbaren Beschichtung hinsichtlich Aufbau und Funktion mit der dritten Ausführungsform überein, auf deren vorstehende Beschreibung insoweit Bezug genommen wird.

Eine in Fig. 16 dargestellte achte Ausführungsform einer Vorrichtung zum Härten einer strahlungshärtbaren Beschichtung unterscheidet sich von den vorstehend beschriebenen Ausführungsformen dadurch, daß zusätzlich mindestens ein Magnetelement 210 zur Erzeugung eines Magnetfelds in dem Plasmaerzeugungsraum 104 vorgesehen ist.

Durch das von dem Magnetelement 210 erzeugte Magnetfeld kann der lokale Ionisierungsgrad des Plasmas und damit die Strahlungsverteilung in der Plasmakammer 124 beeinflußt werden.

Das Magnetelement 210 kann als Permanentmagnet oder als Elektromagnet ausgebildet sein.

Eine Ausbildung als Elektromagnet eignet sich insbesondere dazu, ein zeitlich variables Magnetfeld mittels des Magnetelements 210 zu erzeugen.

Insbesondere kann vorgesehen sein, daß das Magnetfeld mittels des Magnetelements 210 erst nach Beginn des Härtungsvorgangs der Beschichtung 100, beispielsweise erst nach Ablauf von ungefähr der halben Härtungszeit, erzeugt wird, um die Strahlungsintensität, mit der besonders exponierte Stellen des Werkstücks 102 beaufschlagt werden, zu reduzieren.

Insbesondere kann auf diese Weise eine Vergilbung beim Aushärten von hellen Lacken, insbesondere von weißen Lacken, vermieden werden.

Im übrigen stimmt die achte Ausführungsform einer Vorrichtung zum Härten einer strahlungshärtbaren Beschichtung hinsichtlich Aufbau und Funktion mit der dritten Ausführungsform überein, auf deren vorstehende Beschreibung insoweit Bezug genommen wird.

Insbesondere im Falle von Werkstücken 102 aus einem elektrisch leitfähigen Material kann es zur Stabilisierung des erzeugten Plasmas von Vorteil sein, wenn das mit der Beschichtung 100 versehene Werkstück 102 und die Begrenzungswände der Plasmakammer 124 auf dasselbe elektrische Potential gelegt werden.

Dies kann insbesondere dadurch erfolgen, daß das Werkstück 102 mittels einer elektrisch leitfähigen Werkstückhalterung elektrisch leitend mit den Begrenzungswänden der Plasmakammer 124 verbunden wird.

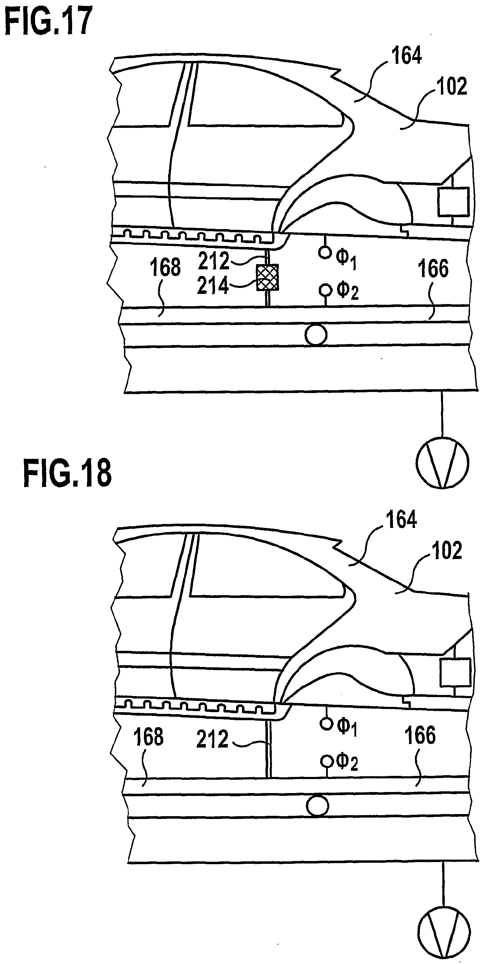

Beispielhaft ist in Fig. 18 eine Fahrzeugkarosserie 164 dargestellt, welche über eine elektrisch leitfähige Werkstückhalterung 212 mit einem Skidrahmen 166 verbunden ist, welcher seinerseits in elektrisch leitfähiger Verbindung mit den Begrenzungswänden der Plasmakammer 124 steht. In diesem Fall ist gewährleistet, daß das Werkstück (die Fahrzeugkarosserie 164) auf einem elektrischen Potential φ₁ liegt, welches mit dem elektrischen Potential φ₂ übereinstimmt, auf welchem der Skidrahmen 166 und die Begrenzungswände der Plasmakammer 124 liegen.

Insbesondere kann vorgesehen sein, daß das Werkstück 102 und die Begrenzungswände der Plasmakammer 124 auf Massepotential liegen.

Alternativ hierzu kann es aber auch von Fall zu Fall vorteilhaft sein, das Werkstück 102 auf ein elektrisches Potential zu legen, welches von dem elektrischen Potential der Begrenzungswände der Plasmakammer 124 verschieden ist.

In diesem Fall ist es erforderlich, das Werkstück 102 durch einen elektrischen Isolator von den Begrenzungswänden der Plasmakammer 124 zu trennen.

Beispielhaft hierfür ist in Fig. 17 eine Fahrzeugkarosserie 164 dargestellt, welche über eine Werkstückhalterung 212 mechanisch mit einem Skidrahmen 166 verbunden ist. Die Werkstückhalterung 212 umfaßt in diesem Fall jedoch einen elektrischen Isolator 214, welcher einen werkstückseitigen Teil der Werkstückhalterung 212 elektrisch von einem skidrahmenseitigen Teil der Werkstückhalterung 212 trennt.

In diesem Fall kann das elektrische Potential φ₁ des Werkstücks (Fahrzeugkarosserie 164) von dem elektrischen Potential φ₂ des Skidrahmens 166 und der Begrenzungswände der Plasmakammer 124 verschieden sein.

Das Potential φ₁ des Werkstücks 102 kann auf ein definiertes Niveau, beispielsweise auf das Massepotential oder ein von dem Massepotential verschiedenes Potential, gelegt werden.

Alternativ hierzu kann auch vorgesehen sein, daß das Werkstück 102 nicht auf ein extern vorgegebenes Potential gelegt, sondern variabel gehalten wird.

Der elektrische Isolator 214 kann aus einem beliebigen Material mit ausreichender elektrischer Isolationswirkung, beispielsweise aus einem geeigneten Kunststoffmaterial oder einem geeigneten keramischen Material, gebildet sein.

Vorzugsweise wird der elektrische Isolator 214 aus einem vakuumbeständigen Material gebildet.

## Patentansprüche

1. Verfahren zum Härten einer Beschichtung (100) an einem Werkstück (102),
**dadurch kennzeichnet,**
**dass** das Werkstück nicht-planar ausgebildet und mit einer Beschichtung (100) versehen ist, die durch eine elektromagnetische Strahlung härtbar ist, dass das Werkstück (102) in einem Plasmaerzeugungsraum (104) angeordnet wird und dass in dem Plasmaerzeugungsraum (104) durch Einkopplung von elektromagnetischer Strahlung in den Plasmaerzeugungsraum (104) mittels mindestens einer Einkopplungseinrichtung (132, 132') ein Plasma erzeugt wird, in dem eine zum Härten der Beschichtung (100) geeignete elektromagnetische Strahlung erzeugt wird, mittels welcher die Beschichtung (100) zumindest teilweise gehärtet wird.

2. Verfahren nach Anspruch 1, **dadurch gekennzeichnet, dass** in dem Plasma eine elektromagnetische Strahlung mit einer Wellenlänge im Bereich von ungefähr 50 nm bis ungefähr 850 nm, insbesondere im Bereich von ungefähr 50 nm bis ungefähr 700 nm, vorzugsweise im Bereich von ungefähr 150 nm bis ungefähr 700 nm, besonders bevorzugt im Bereich von ungefähr 200 nm bis ungefähr 600 nm, erzeugt wird.

3. Verfahren nach Anspruch 2, **dadurch gekennzeichnet, dass** das Werkstück mit einer Beschichtung (100) versehen ist, die durch eine elektromagnetische Strahlung, welche zumindest einen Anteil von UV-Strahlung umfasst, härtbar ist.

4. Verfahren nach einem der Ansprüche 1 bis 3, **dadurch gekennzeichnet, dass** der Druck in dem Plasmaerzeugungsraum (104) auf einen Wert von höchstens ungefähr 100 Pa, vorzugsweise von höchstens ungefähr 1 Pa, insbesondere von höchstens ungefähr 0,1 Pa, eingestellt wird.

5. Verfahren nach einem der Ansprüche 1 bis 4, **dadurch gekennzeichnet, dass** der Plasmaerzeugungsraum (104) als Prozessgas Stickstoff und/oder ein Edelgas, vorzugsweise Argon, enthält.

6. Verfahren nach einem der Ansprüche 1 bis 5, **dadurch gekennzeichnet, dass** der Plasmaerzeugungsraum (104) ein Prozessgas enthält, dem ein Additiv, beispielsweise ein Metall und/oder ein Metallhalogenid, zugesetzt worden ist.

7. Verfahren nach einem der Ansprüche 1 bis 6, **dadurch gekennzeichnet, dass** das Plasma durch Einkopplung von Mikrowellenstrahlung, vorzugsweise mit einer Frequenz im Bereich von ungefähr 1 GHz bis ungefähr 10 GHz, insbesondere im Bereich von ungefähr 2 GHz bis ungefähr 3 GHz, erzeugt wird.

8. Verfahren nach einem der Ansprüche 6 oder 7, **dadurch gekennzeichnet, dass** die elektromagnetische Strahlung mittels eines Magnetrons (140) erzeugt wird.

9. Verfahren nach einem der Ansprüche 6 bis 8, **dadurch gekennzeichnet, dass** ein Magnetfeld zur Erzeugung eines ECR-Effektes erzeugt wird.

10. Verfahren nach einem der Ansprüche 1 bis 9, **dadurch gekennzeichnet, dass** die elektromagnetische Strahlung mittels mehrerer Einkopplungseinrichtungen (132, 132') in den Plasmaerzeugungsraum (104) eingekoppelt wird.

11. Verfahren nach einem der Ansprüche 1 bis 10, **dadurch gekennzeichnet, dass** das Werkstück (102) einen Hohlraum (152) mit einer Zugangsöffnung (154) aufweist und dass elektromagnetische Strahlung mittels mindestens einer Einkopplungseinrichtung (132) so in den Plasmaerzeugungsraum (104) eingekoppelt wird, dass die elektromagnetische Strahlung durch die Zugangsöffnung (154) in den Hohlraum (152) des Werkstücks (102) gelangt.

12. Verfahren nach einem der Ansprüche 1 bis 11, **dadurch gekennzeichnet, dass** dem Plasmaerzeugungsraum (104) während des Härtungsvorganges ein zu ionisierendes Gas zugeführt wird.

13. Verfahren nach Anspruch 12, **dadurch gekennzeichnet, dass** das zu ionisierende Gas dem Plasmaerzeugungsraum (104) mittels einer Einspeiseinrichtung (144) zugeführt wird, die einer Einkopplungseinrichtung (132, 132') benachbart ist, mittels welcher eine elektromagnetische Strahlung in den Plasmaerzeugungsraum (104) eingekoppelt wird.

14. Verfahren nach einem der Ansprüche 1 bis 13, **dadurch gekennzeichnet, dass** das Werkstück (102) in eine Vorkammer (160) eingebracht und für den Härtungsvorgang aus der Vorkammer (160) in den Plasmaerzeugungsraum (104) überführt wird.

15. Verfahren nach Anspruch 14, **dadurch gekennzeichnet, dass** die Vorkammer (160) nach dem Einbringen des Werkstücks (102) evakuiert wird.

16. Verfahren nach einem der Ansprüche 14 oder 15, **dadurch gekennzeichnet, dass** das Werkstück (102) in der Vorkammer (160) mit elektromagnetischer Strahlung, insbesondere mit Mikrowellenstrahlung, beaufschlagt wird.

17. Verfahren nach einem der Ansprüche 1 bis 16, **dadurch gekennzeichnet, dass** das Werkstück (102) nach dem Härtungsvorgang aus dem Plasmaerzeugungsraum (104) in eine Ausschleuskammer (162) überführt wird.

18. Verfahren nach Anspruch 17, **dadurch gekennzeichnet, dass** die Ausschleuskammer (162) vor dem Überführen des Werkstücks (102) in die Ausschleuskammer (162) evakuiert wird.

19. Verfahren nach einem der Ansprüche 1 bis 18, **dadurch gekennzeichnet, dass** das Werkstück (102) mindestens eine Hinterschneidung und/oder mindestens einen abgeschatteten Bereich aufweist.

20. Verfahren nach einem der Ansprüche 1 bis 19, **dadurch gekennzeichnet, dass** das Werkstück (102) ein elektrisch leitfähiges Material umfasst.

21. Verfahren nach einem der Ansprüche 1 bis 20, **dadurch gekennzeichnet, dass** das Werkstück (102) ein metallisches Material umfasst.

22. Verfahren nach einem der Ansprüche 1 bis 21, **dadurch gekennzeichnet, dass** das Werkstück (102) ein Kunststoffmaterial und/oder Holz umfasst.

23. Verfahren nach einem der Ansprüche 1 bis 22, **dadurch gekennzeichnet, dass** der Plasmaerzeugungsraum (104) als Prozessgas Stickstoff, Helium und/oder Argon enthält.

24. Verfahren nach einem der Ansprüche 1 bis 23, **dadurch gekennzeichnet, dass** der Plasmaerzeugungsraum (104) ein Prozessgas enthält, dessen Zusammensetzung während des Härtungsvorganges variiert.

25. Verfahren nach Anspruch 24, **dadurch gekennzeichnet, dass** die Zusammensetzung des Prozessgases so variiert, dass der Schwerpunkt der in dem Plasma während des Härtungsvorgangs erzeugten elektromagnetischen Strahlung während einer ersten Phase des Härtungsvorgangs bei einer ersten Wellenlänge liegt und während einer späteren, zweiten Phase des Härtungsvorgangs bei einer zweiten Wellenlänge liegt, wobei die zweite Wellenlänge von der ersten Wellenlänge verschieden ist.

26. Verfahren nach Anspruch 25, **dadurch gekennzeichnet, dass** die zweite Wellenlänge kleiner ist als die erste Wellenlänge.

27. Verfahren nach einem der Ansprüche 24 bis 26, **dadurch gekennzeichnet, dass** die Zusammensetzung des Prozessgases so variiert wird, dass sich der Schwerpunkt der in dem Plasma während des Härtungsvorgangs erzeugten elektromagnetischen Strahlung mit wachsender Härtungsdauer zu kleineren Wellenlängen hin verschiebt.

28. Verfahren nach einem der Ansprüche 1 bis 27, **dadurch gekennzeichnet, dass** der Plasmaerzeugungsraum (104) zu dem Zeitpunkt, in dem das Plasma gezündet wird, Argon, vorzugsweise im wesentlichen ausschließlich Argon, enthält.

29. Verfahren nach einem der Ansprüche 1 bis 28, **dadurch gekennzeichnet, dass** dem Plasmaerzeugungsraum (104) über eine oder mehrere Einspeiseinrichtungen (144) ein oder mehrere Gase und/oder ein Gasgemisch zugeführt werden.

30. Verfahren nach einem der Ansprüche 1 bis 29, **dadurch gekennzeichnet, dass** das Plasma durch Einkopplung von elektromagnetischer Strahlung in den Plasmaerzeugungsraum (104) mittels mehrerer Einkopplungseinrichtungen (132, 132') erzeugt wird, wobei mindestens zwei der Einkopplungseinrichtungen (132, 132') voneinander verschiedene Einkopplungsleistungen aufweisen.

31. Verfahren nach einem der Ansprüche 1 bis 30, **dadurch gekennzeichnet, dass** das Plasma durch Einkopplung von elektromagnetischer Strahlung in den Plasmaerzeugungsraum (104) mittels mehrerer Einkopplungseinrichtungen (132, 132') erzeugt wird, wobei mindestens zwei der Einkopplungseinrichtungen (132, 132') von unterschiedlicher Bauart sind.

32. Verfahren nach einem der Ansprüche 1 bis 31, **dadurch gekennzeichnet, dass** in dem Plasmaerzeugungsraum (104) mindestens ein Reflektor (202) zum Reflektieren der in dem Plasma erzeugten elektromagnetischen Strahlung vorgesehen ist.

33. Verfahren nach Anspruch 32, **dadurch gekennzeichnet, dass** in dem Plasmaerzeugungsraum (104) mindestens eine Spiegelfolie als Reflektor (202) vorgesehen ist.

34. Verfahren nach einem der Ansprüche 32 oder 33, **dadurch gekennzeichnet, dass** zumindest ein Teilbereich der Begrenzungswände des Plasmaerzeugungsraums (104) als Reflektor (202) ausgebildet ist.

35. Verfahren nach einem der Ansprüche 32 bis 34, **dadurch gekennzeichnet, dass** der mindestens eine Reflektor (202) als reflektierendes Material Aluminium und/oder Edelstahl umfasst.

36. Verfahren nach einem der Ansprüche 32 bis 35, **dadurch gekennzeichnet, dass** der mindestens eine Reflektor (202) aus dem Plasmaerzeugungsraum (104) entnehmbar ist.

37. Verfahren nach einem der Ansprüche 1 bis 36, **dadurch gekennzeichnet, dass** Gas aus dem Plasmaerzeugungsraum (104) über eine oder mehrere Absaugeinrichtungen (208) abgesaugt wird.

38. Verfahren nach einem der Ansprüche 1 bis 37, **dadurch gekennzeichnet, dass** der Druck in dem Plasmaerzeugungsraum (104) mittels mindestens einer Absaugeinrichtung (208) mit einer Drosselklappe (200) variiert wird.

39. Verfahren nach einem der Ansprüche 1 bis 38, **dadurch gekennzeichnet, dass** das Werkstück (102) mittels einer zumindest teilweise elektrisch isolierenden Halterung (212) elektrisch von den Begrenzungswänden des Plasmabegrenzungsraums (104) getrennt wird.

40. Verfahren nach einem der Ansprüche 1 bis 39, **dadurch gekennzeichnet, dass** das Werkstück (102) auf ein von dem elektrischen Potential der Begrenzungswände des Plasmaerzeugungsraums (104) verschiedenes elektrisches Potential gelegt wird.

41. Verfahren nach einem der Ansprüche 1 bis 40, **dadurch gekennzeichnet, dass** das Werkstück (102) mittels einer elektrisch leitfähigen Halterung elektrisch leitend mit den Begrenzungswänden des Plasmaerzeugungsraums (104) verbunden wird.

42. Verfahren nach einem der Ansprüche 1 bis 41, **dadurch gekennzeichnet, dass** das Werkstück (102) auf dasselbe elektrische Potential wie die Begrenzungswände des Plasmaerzeugungsraums (104) gelegt wird.

43. Verfahren nach einem der Ansprüche 1 bis 42, **dadurch gekennzeichnet, dass** das Werkstück (102) auf Massepotential gelegt wird.

44. Verfahren nach einem der Ansprüche 1 bis 43, **dadurch gekennzeichnet, dass** das Werkstück (102) mit einer Beschichtung (100) versehen ist, die durch elektromagnetische Strahlung, welche zumindest einen Anteil von UV-Strahlung umfasst, oder durch Wärme oder durch eine Kombination von elektromagnetischer Strahlung, welche zumindest einen Anteil von UV-Strahlung umfasst, und Wärme härtbar ist.

45. Verfahren nach einem der Ansprüche 1 bis 44, **dadurch gekennzeichnet, dass** das Werkstück (102) vor, während und/oder nach der Erzeugung des Plasmas mit einer elektromagnetischen Strahlung, die nicht in dem Plasma erzeugt wird, beaufschlagt wird.

46. Verfahren nach Anspruch 45, **dadurch gekennzeichnet, dass** das Werkstück (102) vor, während und/oder nach der Erzeugung des Plasmas mit Mikrowellenstrahlung und/oder mit Infrarot-Strahlung, die nicht in dem Plasma erzeugt wird, beaufschlagt wird.

47. Verfahren nach einem der Ansprüche 1 bis 45, **dadurch gekennzeichnet, dass** das Werkstück (102) vor, nach und/oder während der Erzeugung des Plasmas getrocknet wird.

48. Verfahren nach einem der Ansprüche 1 bis 47, **dadurch gekennzeichnet, dass** das Werkstück (102) vor der Erzeugung des Plasmas mit einem unterhalb des Atmosphärendruckes liegenden Druck, vorzugsweise mit einem Druck im Bereich von ungefähr 2000 Pa bis ungefähr 50000 Pa, beaufschlagt wird.

49. Verfahren nach einem der Ansprüche 1 bis 48, **dadurch gekennzeichnet, dass** das Werkstück (102) vor der Erzeugung des Plasmas mit einem unterhalb des Atmosphärendrucks liegenden Druck beaufschlagt wird, welcher höher ist als der Druck, mit dem das Werkstück (102) während der Erzeugung des Plasmas beaufschlagt wird.

50. Verfahren nach einem der Ansprüche 1 bis 49, **dadurch gekennzeichnet, dass** in dem Plasmaerzeugungsraum (104) ein Magnetfeld erzeugt wird.

51. Verfahren nach einem der Anspruch 50, **dadurch gekennzeichnet, dass** die Stärke des Magnetfelds während des Härtungsvorgangs variiert wird.

52. Verfahren nach einem der Ansprüche 50 oder 51, **dadurch gekennzeichnet, dass** das Magnetfeld in dem Plasmaerzeugungsraum (104) erst nach Beginn des Härtungsvorgangs erzeugt wird.

53. Verfahren nach einem der Ansprüche 50 bis 52, **dadurch gekennzeichnet, dass** die Stärke des Magnetfelds in dem Plasmaerzeugungsraum (104) räumlich variiert.

54. Fahrzeugkarosserie mit einer Beschichtung (100) in einem Innenraum der Fahrzeugkarosserie (164), die nach dem Verfahren gemäß einem der Ansprüche 1 bis 53 gehärtet worden ist.

55. Vorrichtung zum Härten einer durch elektromagnetische Strahlung härtbaren Beschichtung (100) an einem Werkstück (102), **dadurch gekennzeichnet, dass** die Vorrichtung (122) einen Plasmaerzeugungsraum (104), eine Einrichtung (170) zum Einbringen des Werkstücks (102) in den Plasmaerzeugungsraum (104) und eine Einrichtung (132, 132', 136, 140) zum Erzeugen eines Plasmas in dem Plasmaerzeugungsraum (104) umfasst, wobei in dem Plasma eine zum Härten der Beschichtung (100) an dem Werkstück (102) geeignete elektromagnetische Strahlung erzeugbar ist und mittels dieser elektromagnetischen Strahlung die Beschichtung (100) zumindest teilweise härtbar ist, und
dass die Vorrichtung (122) mindestens eine Einkopplungseinrichtung (132, 132') zum Einkoppeln von elektromagnetischer Strahlung in den Plasmaerzeugungsraum (104) umfasst,
wobei mindestens eine Einkopplungseinrichtung (132') so angeordnet und ausgerichtet ist, dass die mittels dieser Einkopplungseinrichtung (132') in den Plasmaerzeugungsraum (104) eingekoppelte elektromagnetische Strahlung durch eine Zugangsöffnung (154) in einen Hohlraum (152) des in dem Plasmaerzeugungsraum (104) angeordneten Werkstücks (102) gelangt.

56. Vorrichtung nach Anspruch 55, **dadurch gekennzeichnet, dass** in dem Plasmaerzeugungsraum (104) ein Plasma erzeugbar ist, das eine elektromagnetische Strahlung mit einer Wellenlänge im Bereich von ungefähr 50 nm bis ungefähr 850 nm, insbesondere im Bereich von ungefähr 50 nm bis ungefähr 700 nm, vorzugsweise im Bereich von ungefähr 150 nm bis ungefähr 700 nm, besonders bevorzugt im Bereich von ungefähr 200 nm bis ungefähr 600 nm, emittiert.

57. Vorrichtung nach einem der Ansprüche 55 oder 56, **dadurch gekennzeichnet, dass** der Druck eines Prozessgases in dem Plasmaerzeugungsraum (104) auf einen Wert von höchstens ungefähr 100 Pa, vorzugsweise von höchstens ungefähr 1 Pa, insbesondere von höchstens ungefähr 0,1 Pa, einstellbar ist.

58. Vorrichtung nach einem der Ansprüche 55 bis 57, **dadurch gekennzeichnet, dass** der Plasmaerzeugungsraum (104) als Prozessgas Stickstoff oder ein Edelgas, vorzugsweise Argon, enthält.

59. Vorrichtung nach einem der Ansprüche 55 bis 58, **dadurch gekennzeichnet, dass** mittels der Einkopplungseinrichtung (132, 132') eine Mikrowellenstrahlung, vorzugsweise mit einer Frequenz im Bereich von ungefähr 1 GHz bis ungefähr 10 GHz, insbesondere im Bereich von ungefähr 2 GHz bis ungefähr 3 GHz, in den Plasmaerzeugungsraum (104) einkoppelbar ist.

60. Vorrichtung nach einem der Ansprüche 55 bis 59, **dadurch gekennzeichnet, dass** die Vorrichtung (122) eine Einrichtung (140) zum Erzeugen elektromagnetischer Strahlung umfasst.

61. Vorrichtung nach einem der Ansprüche 55 bis 60, **dadurch gekennzeichnet, dass** die Vorrichtung (122) eine Einrichtung (138) zum Erzeugen eines Magnetfeldes in dem Plasmaerzeugungsraum (104) umfasst.

62. Vorrichtung nach einem der Ansprüche 55 bis 61, **dadurch gekennzeichnet, dass** die Vorrichtung (122) mehrere Einkopplungseinrichtungen (132, 132') zum Einkoppeln von elektromagnetischer Strahlung in den Plasmaerzeugungsraum (104) umfasst.

63. Vorrichtung nach einem der Ansprüche 55 bis 62, **dadurch gekennzeichnet, dass** die Vorrichtung (122) mindestens eine Einspeiseinrichtung (144) zum Zuführen eines zu ionisierenden Gases zu dem Plasmaerzeugungsraum (104) umfasst.

64. Vorrichtung nach Anspruch 63, **dadurch gekennzeichnet, dass** die Einspeiseinrichtung (144) benachbart zu einer Einkopplungseinrichtung (132, 132') angeordnet ist, mittels welcher eine elektromagnetische Strahlung in den Plasmaerzeugungsraum (104) einkoppelbar ist.

65. Vorrichtung nach einem der Ansprüche 55 bis 64, **dadurch gekennzeichnet, dass** die Vorrichtung (122) eine Vorkammer (160) zur Aufnahme des Werkstücks (102) vor dem Härtungsvorgang umfasst.

66. Vorrichtung nach Anspruch 65, **dadurch gekennzeichnet, dass** die Vorkammer (160) evakuierbar ist.

67. Vorrichtung nach einem der Ansprüche 65 oder 66, **dadurch gekennzeichnet, dass** die Vorkammer (160) mit einer Einrichtung (132, 136, 140) zum Beaufschlagen des Werkstücks (102) in der Vorkammer (160) mit einer elektromagnetischen Strahlung, insbesondere mit einer Mikrowellenstrahlung, versehen ist.

68. Vorrichtung nach einem der Ansprüche 65 bis 67, **dadurch gekennzeichnet, dass** die Vorrichtung (122) eine Fördervorrichtung (170), vorzugsweise eine Rollenbahn, zum Fördern des Werkstücks (102) von der Vorkammer (160) in den Plasmaerzeugungsraum (104) umfasst.

69. Vorrichtung nach einem der Ansprüche 55 bis 68, **dadurch gekennzeichnet, dass** die Vorrichtung (122) eine Ausschleuskammer (162) zur Aufnahme des Werkstücks (102) nach dem Härtungsvorgang umfasst.

70. Vorrichtung nach Anspruch 69, **dadurch gekennzeichnet, dass** die Ausschleuskammer (162) evakuierbar ist.

71. Vorrichtung nach einem der Ansprüche 69 oder 70, **dadurch gekennzeichnet, dass** die Vorrichtung (122) eine Fördervorrichtung (170), vorzugsweise eine Rollenbahn, zum Fördern des Werkstücks (102) aus dem Plasmaerzeugungsraum (104) in die Ausschleuskammer (162) umfasst.

72. Vorrichtung nach einem der Ansprüche 55 bis 71, **dadurch gekennzeichnet, dass** die Vorrichtung zum Härten einer Beschichtung (100) an einem nicht-planaren Werkstück (102) ausgebildet ist.

73. Vorrichtung nach einem der Ansprüche 55 bis 72, **dadurch gekennzeichnet, dass** die Vorrichtung zum Aushärten einer Beschichtung (100) an einem Werkstück (102), das mindestens eine Hinterschneidung und/oder mindestens einen abgeschatteten Bereich aufweist, ausgebildet ist.

74. Vorrichtung nach einem der Ansprüche 55 bis 73, **dadurch gekennzeichnet, dass** die Vorrichtung zum Härten einer Beschichtung (100) an einem Werkstück (102), das ein elektrisch leitfähiges Material umfasst, ausgebildet ist.

75. Vorrichtung nach einem der Ansprüche 55 bis 74, **dadurch gekennzeichnet, dass** die Vorrichtung zum Härten einer Beschichtung (100) an einem Werkstück (102), das ein metallisches Material umfasst, ausgebildet ist.

76. Vorrichtung nach einem der Ansprüche 55 bis 75, **dadurch gekennzeichnet, dass** die Vorrichtung zum Härten einer Beschichtung (100) an einem Werkstück (102), das ein Kunststoffmaterial und/oder Holz umfasst, ausgebildet ist.

77. Vorrichtung nach einem der Ansprüche 55 bis 76, **dadurch gekennzeichnet, dass** dem Plasmaerzeugungsraum (104) als Prozessgas Stickstoff, Helium und/oder Argon zuführbar ist.

78. Vorrichtung nach einem der Ansprüche 55 bis 77, **dadurch gekennzeichnet, dass** der Plasmaerzeugungsraum (104) ein Prozessgas enthält, dessen Zusammensetzung während des Härtungsvorganges variiert.

79. Vorrichtung nach Anspruch 78, **dadurch gekennzeichnet, dass** die Zusammensetzung des Prozessgases so variiert, dass der Schwerpunkt der in dem Plasma während des Härtungsvorgangs erzeugten elektromagnetischen Strahlung während einer Phase des Härtungsvorgangs bei einer ersten Wellenlänge liegt und während einer späteren, zweiten Phase des Härtungsvorgangs bei einer zweiten Wellenlänge liegt, wobei die zweite Wellenlänge von der ersten Wellenlänge verschieden ist.

80. Vorrichtung nach Anspruch 79, **dadurch gekennzeichnet, dass** die zweite Wellenlänge kleiner ist als die erste Wellenlänge.

81. Vorrichtung nach einem der Ansprüche 78 bis 80, **dadurch gekennzeichnet, dass** die Zusammensetzung des Prozessgases in dem Plasmaerzeugungsraum (104) so variierbar ist, dass sich der Schwerpunkt der in dem Plasma während des Härtungsvorgangs erzeugten elektromagnetischen Strahlung mit wachsender Härtungsdauer zu kleineren Wellenlängen hin verschiebt.

82. Vorrichtung nach einem der Ansprüche 55 bis 81, **dadurch gekennzeichnet, dass** der Plasmaerzeugungsraum (104) zu dem Zeitpunkt, in dem das Plasma gezündet wird, Argon, vorzugsweise im Wesentlichen ausschließlich Argon, enthält.

83. Vorrichtung nach einem der Ansprüche 55 bis 82, **dadurch gekennzeichnet, dass** die Vorrichtung eine oder mehrere Einspeiseinrichtungen (144) umfasst, über welche dem Plasmaerzeugungsraum (104) ein oder mehrere Gase und/oder ein Gasgemisch zuführbar sind.

84. Vorrichtung nach einem der Ansprüche 55 bis 83, **dadurch gekennzeichnet, dass** die Vorrichtung mehrere Einkopplungseinrichtungen (132, 132') zum Erzeugen des Plasmas durch Einkopplung von elektromagnetischer Strahlung in den Plasmaerzeugungsraum (104) umfasst, wobei mindestens zwei der Einkopplungseinrichtungen (132, 132') voneinander verschiedene Einkopplungsleistungen aufweisen.

85. Vorrichtung nach einem der Ansprüche 55 bis 84, **dadurch gekennzeichnet, dass** die Vorrichtung mehrere Einkopplungseinrichtungen (132, 132') zum Erzeugen des Plasmas durch Einkopplung von elektromagnetischer Strahlung in den Plasmaerzeugungsraum (104) umfasst, wobei mindestens zwei der Einkopplungseinrichtungen (132, 132') von unterschiedlicher Bauart sind.

86. Vorrichtung nach einem der Ansprüche 55 bis 85, **dadurch gekennzeichnet, dass** in dem Plasmaerzeugungsraum (104) mindestens ein Reflektor (202) zum Reflektieren der in dem Plasma erzeugten elektromagnetischen Strahlung vorgesehen ist.

87. Vorrichtung nach Anspruch 86, **dadurch gekennzeichnet, dass** in dem Plasmaerzeugungsraum (104) mindestens eine Spiegelfolie als Reflektor vorgesehen ist.

88. Vorrichtung nach einem der Ansprüche 86 oder 87, **dadurch gekennzeichnet, dass** zumindest ein Teilbereich der Begrenzungswände des Plasmaerzeugungsraums (104) als Reflektor (202) ausgebildet ist.

89. Vorrichtung nach einem der Ansprüche 86 bis 88, **dadurch gekennzeichnet, dass** der mindestens eine Reflektor (202) als reflektierendes Material Aluminium und/oder Edelstahl umfasst.

90. Vorrichtung nach einem der Ansprüche 86 bis 89, **dadurch gekennzeichnet, dass** der mindestens eine Reflektor (202) aus dem Plasmaerzeugungsraum (104) entnehmbar ist.

91. Vorrichtung nach einem der Ansprüche 55 bis 90, **dadurch gekennzeichnet, dass** die Vorrichtung eine oder mehrere Absaugeinrichtungen (208) zum Absaugen von Gas aus dem Plasmaerzeugungsraums (104) umfasst.

92. Vorrichtung nach einem der Ansprüche 55 bis 91, **dadurch gekennzeichnet, dass** die Vorrichtung mindestens eine Absaugeinrichtung (208) mit mindestens einer Drosselklappe (200) zum Variieren des Drucks in dem Plasmaerzeugungsraum (104) umfasst.

93. Vorrichtung nach einem der Ansprüche 55 bis 92, **dadurch gekennzeichnet, dass** die Vorrichtung eine zumindest teilweise elektrisch isolierende Halterung (212) umfasst, mittels welcher das Werkstück (102) elektrisch von den Begrenzungswänden des Plasmabegrenzungsraums (104) getrennt ist.

94. Vorrichtung nach einem der Ansprüche 55 bis 93, **dadurch gekennzeichnet, dass** das Werkstück (102) auf ein von dem elektrischen Potential der Begrenzungswände des Plasmaerzeugungsraums (104) verschiedenes elektrisches Potential legbar ist.

95. Vorrichtung nach einem der Ansprüche 55 bis 94, **dadurch gekennzeichnet, dass** die Vorrichtung eine elektrisch leitfähige Halterung (212) umfasst, mittels welcher das Werkstück (102) elektrisch leitend mit den Begrenzungswänden des Plasmaerzeugungsraums (104) verbunden ist.

96. Vorrichtung nach einem der Ansprüche 55 bis 95, **dadurch gekennzeichnet, dass** das Werkstück (102) auf dasselbe elektrische Potential wie die Begrenzungswände des Plasmaerzeugungsraums (104) legbar ist.

97. Vorrichtung nach einem der Ansprüche 55 bis 96, **dadurch gekennzeichnet, dass** das Werkstück (102) auf Massepotential legbar ist.

98. Vorrichtung nach einem der Ansprüche 55 bis 97, **dadurch gekennzeichnet, dass** die Vorrichtung zum Härten einer Beschichtung (100) an dem Werkstück (102), die durch elektromagnetische Strahlung, welche zumindest einen Anteil von UV-Strahlung umfasst, oder durch Wärme oder durch eine Kombination von elektromagnetischer Strahlung, welche zumindest einen Anteil von UV-Strahlung umfasst, und Wärme härtbar ist, ausgebildet ist.

99. Vorrichtung nach einem der Ansprüche 55 bis 98, **dadurch gekennzeichnet, dass** die Vorrichtung eine Einrichtung zum Beaufschlagen des Werkstücks (102) vor, während und/oder nach der Erzeugung des Plasmas mit einer elektromagnetischen Strahlung, die nicht in dem Plasma erzeugt wird, vorzugsweise mit Mikrowellenstrahlung und/oder mit Infrarot-Strahlung, umfasst.

100. Vorrichtung nach einem der Ansprüche 55 bis 99, **dadurch gekennzeichnet, dass** die Vorrichtung eine Einrichtung zum Trocknen des Werkstücks (102) vor, nach und/oder während der Erzeugung des Plasmas umfasst.

101. Vorrichtung nach einem der Ansprüche 55 bis 100, **dadurch gekennzeichnet, dass** die Vorrichtung eine Einrichtung zum Beaufschlagen des Werkstücks (102) mit einem unterhalb des Atmosphärendrucks liegenden Druck, vorzugsweise mit einem Druck im Bereich von ungefähr 2000 Pa bis ungefähr 50000 Pa, vor der Erzeugung des Plasmas umfasst.

102. Vorrichtung nach einem der Ansprüche 55 bis 101, **dadurch gekennzeichnet, dass** die Vorrichtung eine Einrichtung zum Beaufschlagen des Werkstücks (102) mit einem unterhalb des Atmosphärendrucks liegenden Druck, welcher höher ist als der Druck, mit dem das Werkstück (102) während der Erzeugung des Plasmas beaufschlagt wird, vor der Erzeugung des Plasmas umfasst.

103. Vorrichtung nach einem der Ansprüche 55 bis 102, **dadurch gekennzeichnet, dass** die Vorrichtung eine Einrichtung zum Erzeugen eines Magnetfeldes in dem Plasmaerzeugungsraum (104) umfasst.

104. Vorrichtung nach Anspruch 103, **dadurch gekennzeichnet, dass** die Stärke des von der Einrichtung zur Erzeugung des Magnetfelds erzeugten Magnetfeldes während des Härtungsvorgangs variierbar ist.

105. Vorrichtung nach einem der Ansprüche 103 oder 104, **dadurch gekennzeichnet, dass** die Erzeugung des Magnetfelds in dem Plasmaerzeugungsraum (104) relativ zu dem Beginn des Härtungsvorgangs verzögerbar ist.

106. Vorrichtung nach einem der Ansprüche 103 bis 105, **dadurch gekennzeichnet, dass** die Stärke des mittels der Einrichtung zur Erzeugung eines Magnetfelds erzeugten Magnetfeldes in dem Plasmaerzeugungsraum (104) räumlich variabel ist.

## Claims

1. Process for curing a coating (100) on a work piece (102),
**characterised in that** the work piece is non-planar and is provided with a coating (100) which is curable by electromagnetic radiation, **in that** the work piece (102) is disposed in a plasma generation area (104), and **in that** in the plasma generation area (104) a plasma is generated by the input of electromagnetic radiation into the plasma generation area (104) by means of at least one input device (132, 132'), in which plasma an electromagnetic radiation suitable for curing the coating (100) is generated, by means of which the coating (100) is at least partially cured.

2. Process according to Claim 1, **characterised in that** an electromagnetic radiation with a wavelength in the range of approximately 50 nm to approximately 850 nm, in particular in the range of approximately 50 nm to approximately 700 nm, preferably in the range of approximately 150 nm to approximately 700 nm, particularly preferred in the range of approximately 200 nm to approximately 600 nm, is generated in the plasma.

3. Process according to Claim 2, **characterised in that** the work piece is provided with a coating (100), which is curable by an electromagnetic radiation comprising at least a uv radiation component.

4. Process according to one of Claims 1 to 3, **characterised in that** the pressure in the plasma generation area (104) is set to a value of approximately 100 Pa at maximum, preferably approximately 1 Pa at maximum, in particular approximately 0.1 Pa at maximum.

5. Process according to one of Claims 1 to 4, **characterised in that** the plasma generation area (104) contains nitrogen and/or an inert gas, preferably argon, as process gas.

6. Process according to one of Claims 1 to 5, **characterised in that** the plasma generation area (104) contains a process gas, to which an additive, e.g. a metal and/or a metal halide, has been added.

7. Process according to one of Claims 1 to 6, **characterised in that** the plasma is generated by the input of microwave radiation, preferably with a frequency in the range of approximately 1 GHz to approximately 10 GHz, in particular in the range of approximately 2 GHz to approximately 3 GHz.

8. Process according to one of Claims 6 or 7, **characterised in that** the electromagnetic radiation is generated by means of a magnetron (140).

9. Process according to one of Claims 6 to 8, **characterised in that** a magnetic field is generated for the generation of an ECR effect.

10. Process according to one of Claims 1 to 9, **characterised in that** the electromagnetic radiation is input into the plasma generation area (104) by means of a plurality of input devices (132, 132').

11. Process according to one of Claims 1 to 10, **characterised in that** the work piece (102) has a cavity (152) with an access opening (154), and that electromagnetic radiation is input into the plasma generation area (104) by means of at least one input device (132) so that the electromagnetic radiation passes through the access opening (154) into the cavity (152) of the work piece (102).

12. Process according to one of Claims 1 to 11, **characterised in that** a gas to be ionised is fed to the plasma generation area (104) during the curing process.

13. Process according to Claim 12, **characterised in that** the gas to be ionised is fed to the plasma generation area (104) by means of a feeder device (144), which is adjacent to an input device (132, 132'), by means of which an electromagnetic radiation is input into the plasma generation area (104).

14. Process according to one of Claims 1 to 13, **characterised in that** the work piece (102) is placed into an antechamber (160) and is transferred from the antechamber (160) into the plasma generation area (104) for the curing process.

15. Process according to Claim 14, **characterised in that** the antechamber (160) is evacuated after the work piece (102) has been placed therein.

16. Process according to one of Claims 14 or 15, **characterised in that** the work piece (102) is subjected to electromagnetic radiation, in particular microwave radiation, in the antechamber (160).

17. Process according to one of Claims 1 to 16, **characterised in that** the work piece (102) is transferred from the plasma generation area (104) into a discharge chamber (162) after the curing process.

18. Process according to Claim 17, **characterised in that** before the work piece (102) is transferred into the discharge chamber (162), the discharge chamber (162) is evacuated.

19. Process according to one of Claims 1 to 18, **characterised in that** the work piece (102) has at least one undercut and/or at least one shaded region.

20. Process according to one of Claims 1 to 19, **characterised in that** the work piece (102) comprises an electrically conductive material.

21. Process according to one of Claims 1 to 20, **characterised in that** the work piece (102) comprises a metallic material.

22. Process according to one of Claims 1 to 21, **characterised in that** the work piece (102) comprises a plastics material and/or wood.

23. Process according to one of Claims 1 to 22, **characterised in that** the plasma generation area (104) contains nitrogen, helium and/or argon as process gas.

24. Process according to one of Claims 1 to 23, **characterised in that** the plasma generation area (104) contains a process gas, the composition of which varies during the curing process.

25. Process according to Claim 24, **characterised in that** the composition of the process gas varies such that during a first phase of the curing process the centre of concentration of the electromagnetic radiation generated in the plasma during the curing process lies at a first wavelength and during a later, second phase of the curing process lies at a second wavelength, the second wavelength being different from the first wavelength.

26. Process according to Claim 25, **characterised in that** the second wavelength is less than the first wavelength.

27. Process according to one of Claims 24 to 26, **characterised in that** the composition of the process gas is varied such that the centre of concentration of the electromagnetic radiation generated in the plasma during the curing process shifts towards lower wavelengths as the curing duration increases.

28. Process according to one of Claims 1 to 27, **characterised in that** at the time at which the plasma is ignited, the plasma generation area (104) contains argon, preferably essentially argon only.

29. Process according to one of Claims 1 to 28, **characterised in that** one or more gases and/or a gas mixture are fed to the plasma generation area (104) via one or more feeder devices (144).

30. Process according to one of Claims 1 to 29, **characterised in that** the plasma is generated by the input of electromagnetic radiation into the plasma generation area (104) by means of a plurality of input devices (132, 132'), wherein at least two of the input devices (132, 132') have different input powers from one another.

31. Process according to one of Claims 1 to 30, **characterised in that** the plasma is generated by the input of electromagnetic radiation into the plasma generation area (104) by means of a plurality of input devices (132, 132'), wherein at least two of the input devices (132, 132') differ in design.

32. Process according to one of Claims 1 to 31, **characterised in that** at least one reflector (202) is provided in the plasma generation area (104) to reflect the electromagnetic radiation generated in the plasma.

33. Process according to Claim 32, **characterised in that** at least one mirror film is provided as reflector (202) in the plasma generation area (104).

34. Process according to one of Claims 32 or 33, **characterised in that** at least a sub-region of the boundary walls of the plasma generation area (104) is configured as a reflector (202).

35. Process according to one of Claims 32 to 34, **characterised in that** the at least one reflector (202) comprises aluminium and/or stainless steel as reflective material.

36. Process according to one of Claims 32 to 35, **characterised in that** the at least one reflector (202) is removable from the plasma generation area (104).

37. Process according to one of Claims 1 to 36, **characterised in that** gas is drawn off from the plasma generation area (104) by means of one or more suction devices (208).

38. Process according to one of Claims 1 to 37, **characterised in that** the pressure in the plasma generation area (104) is varied by means of at least one suction device (208) with a throttle valve (200).

39. Process according to one of Claims 1 to 38, **characterised in that** the work piece (102) is electrically separated from the boundary walls of the plasma generation area (104) by means of an at least partially electrically insulating holder (212).

40. Process according to one of Claims 1 to 39, **characterised in that** the work piece (102) is connected to a different electric potential from the electric potential of the boundary walls of the plasma generation area (104).

41. Process according to one of Claims 1 to 40, **characterised in that** the work piece (102) is connected in an electrically conductive manner to the boundary walls of the plasma generation area (104) by means of an electrically conductive holder.

42. Process according to one of Claims 1 to 41, **characterised in that** the work piece (102) is connected to the same electric potential as the boundary walls of the plasma generation area (104).

43. Process according to one of Claims 1 to 42, **characterised in that** the work piece (102) is connected to earth potential.

44. Process according to one of Claims 1 to 43, **characterised in that** the work piece (102) is provided with a coating (100), which is curable by electromagnetic radiation, which comprises at least a uv radiation component, or by heat or by a combination of electromagnetic radiation, which comprises at least a uv radiation component, and heat.

45. Process according to one of Claims 1 to 44, **characterised in that** the work piece (102) is subjected to an electromagnetic radiation, which is not generated in the plasma, before, during and/or after generation of the plasma.

46. Process according to Claim 45, **characterised in that** the work piece (102) is subjected to microwave radiation and/or to infrared radiation, which is not generated in the plasma, before, during and/or after generation of the plasma.

47. Process according to one of Claims 1 to 45, **characterised in that** the work piece (102) is dried before, after and/or during generation of the plasma.

48. Process according to one of Claims 1 to 47, **characterised in that** before generation of the plasma, the work piece (102) is subjected to a pressure lying below atmospheric pressure, preferably to a pressure in the range of approximately 2000 Pa to approximately 50 000 Pa.

49. Process according to one of Claims 1 to 48, **characterised in that** before generation of the plasma, the work piece (102) is subjected to a pressure lying below atmospheric pressure, which is higher than the pressure, to which the work piece (102) is subjected during generation of the plasma.

50. Process according to one of Claims 1 to 49, **characterised in that** a magnetic field is generated in the plasma generation area (104).

51. Process according to Claim 50, **characterised in that** the intensity of the magnetic field is varied during the curing process.

52. Process according to one of Claims 50 or 51, **characterised in that** the magnetic field is generated in the plasma generation area (104) only after the start of the curing process.

53. Process according to one of Claims 50 to 52, **characterised in that** the intensity of the magnetic field varies spatially in the plasma generation area (104).

54. Vehicle body with a coating (100) in an interior space of the vehicle body (164), which has been cured by the process according to one of Claims 1 to 53.

55. Device for curing a coating (100) which is curable by electromagnetic radiation on a work piece (102), **characterised in that** the device (122) comprises a plasma generation area (104), a device (170) for bringing the work piece (102) into the plasma generation area (104) and a device (132, 132', 136, 140) for generating a plasma in the plasma generation area (104), and wherein an electromagnetic radiation for curing the coating (100) on the work piece (102) is configured to be generated in the plasma and by means of the electromagnetic radiation the coating (100) is at least partially curable, and
**in that** the device (122) comprises at least one input device (132, 132') for the input of electromagnetic radiation into the plasma generation area (104),
wherein at least one input device (132') is arranged and oriented such that the electromagnetic radiation input into the plasma generation area (104) by means of this input device (132') passes through an access opening (154) in a cavity (152) of the work piece (102) disposed in the plasma generation area (104).

56. Device according to Claim 55, **characterised in that** in the plasma generation area (104) a plasma is configured to be generated which emits an electromagnetic radiation with a wavelength in the range of approximately 50 nm to approximately 850 nm, in particular in the range of approximately 50 nm to approximately 700 nm, preferably in the range of approximately 150 nm to approximately 700 nm, particularly preferred in the range of approximately 200 nm to approximately 600 nm.

57. Device according to one of Claims 55 or 56, **characterised in that** the pressure of a process gas in the plasma generation area (104) is settable to a value of approximately 100 Pa at maximum, preferably approximately 1 Pa at maximum, in particular approximately 0.1 Pa at maximum.

58. Device according to one of Claims 55 to 57, **characterised in that** the plasma generation area (104) contains nitrogen or an inert gas, preferably argon, as process gas.

59. Device according to one of Claims 55 to 58, **characterised in that** a microwave radiation, preferably with a frequency in the range of approximately 1 GHz to approximately 10 GHz, in particular in the range of approximately 2 GHz to approximately 3 GHz, is couplable into the plasma generation area (104) by means of the input device (132, 132').

60. Device according to one of Claims 55 to 59, **characterised in that** the device (122) comprises a device (140) for generating electromagnetic radiation.

61. Device according to one of Claims 55 to 60, **characterised in that** the device (122) comprises a device (138) for generating a magnetic field in the plasma generation area (104).

62. Device according to one of Claims 55 to 61, **characterised in that** the device (122) comprises a plurality of input devices (132, 132') for the input of electromagnetic radiation into the plasma generation area (104).

63. Device according to one of Claims 55 to 62, **characterised in that** the device (122) comprises at least one feeder device (144) for feeding a gas to be ionised to the plasma generation area (104).

64. Device according to Claim 63, **characterised in that** the feeder device (144) is disposed adjacent to an input device (132, 132'), by means of which an electromagnetic radiation is couplable into the plasma generation area (104).

65. Device according to one of Claims 55 to 64, **characterised in that** the device (122) comprises an antechamber (160) to receive the work piece (102) before the curing process.

66. Device according to Claim 65, **characterised in that** the antechamber (160) is configured to be evacuated.

67. Device according to one of Claims 65 or 66, **characterised in that** the antechamber (160) is provided with a device (132, 136, 140) for subjecting the work piece (102) in the antechamber (16) to an electromagnetic radiation, in particular to a microwave radiation.

68. Device according to one of Claims 65 to 67, **characterised in that** the device (122) comprises a transport device (170), preferably a roller conveyor, to transport the work piece (102) from the antechamber (160) into the plasma generation area (104).

69. Device according to one of Claims 55 to 68, **characterised in that** the device (122) comprises a discharge chamber (162) to receive the work piece (122) after the curing process.

70. Device according to Claim 69, **characterised in that** the discharge chamber (162) is configured to be evacuated.

71. Device according to one of Claims 69 or 70, **characterised in that** the device (122) comprises a transport device (170), preferably a roller conveyor, to transport the work piece (102) out of the plasma generation area (104) into the discharge chamber (162).

72. Device according to one of Claims 55 to 71, **characterised in that** the device is configured for curing a coating (100) on a non-planar work piece (102).

73. Device according to one of Claims 55 to 72, **characterised in that** the device is configured for curing a coating (100) on a work piece (102), which has at least one undercut and/or at least one shaded region.

74. Device according to one of Claims 55 to 73, **characterised in that** the device is configured for curing a coating (100) on a work piece (102), which comprises an electrically conductive material.

75. Device according to one of Claims 55 to 74, **characterised in that** the device is configured for curing a coating (100) on a work piece (102), which comprises a metallic material.

76. Device according to one of Claims 55 to 75, **characterised in that** the device is configured for curing a coating (100) on a work piece (102), which comprises a plastic material and/or wood.

77. Device according to one of Claims 55 to 76, **characterised in that** nitrogen, helium and/or argon is feedable to the plasma generation area (104) as process gas.

78. Device according to one of Claims 55 to 77, **characterised in that** the plasma generation area (104) contains a process gas, the composition of which varies during the curing process.

79. Device according to Claim 78, **characterised in that** the composition of the process gas varies such that during a first phase of the curing process the centre of concentration of the electromagnetic radiation generated in the plasma during the curing process lies at a first wavelength and during a later, second phase of the curing process lies at a second wavelength, the second wavelength being different from the first wavelength.

80. Device according to Claim 79, **characterised in that** the second wavelength is less than the first wavelength.

81. Device according to one of Claims 78 to 80, **characterised in that** the composition of the process gas in the plasma generation area (104) is configured to be varied such that the centre of concentration of the electromagnetic radiation generated in the plasma during the curing process shifts towards lower wavelengths as the curing duration increases.

82. Device according to one of Claims 55 to 81, **characterised in that** at the time at which the plasma is ignited, the plasma generation area (104) contains argon, preferably essentially argon only.

83. Device according to one of Claims 55 to 82, **characterised in that** the device comprises one or more feeder device (144) by means of which one or more gases and/or a gas mixture are configured to be fed to the plasma generation area (104).

84. Device according to one of Claims 55 to 83, **characterised in that** the device comprises a plurality of input devices (132, 132') for generation of the plasma by the input of electromagnetic radiation into the plasma generation area (104), wherein at least two of the input devices (132, 132') have different input powers from one another.

85. Device according to one of Claims 55 to 84, **characterised in that** the device comprises a plurality of input devices (132, 132') for generation of the plasma by the input of electromagnetic radiation into the plasma generation area (104), wherein at least two of the input devices (132, 132') differ in design.

86. Device according to one of Claims 55 to 85, **characterised in that** at least one reflector (202) is provided in the plasma generation area (104) to reflect the electromagnetic radiation generated in the plasma.

87. Device according to Claim 86, **characterised in** at least one mirror film is provided as reflector (202) in the plasma generation area (104).

88. Device according to one of Claims 86 or 87, **characterised in that** at least a sub-region of the boundary walls of the plasma generation area (104) is configured as a reflector (202).

89. Device according to one of Claims 86 to 88, **characterised in that** the at least one reflector (202) comprises aluminium and/or stainless steel as reflective material.

90. Device according to one of Claims 86 to 89, **characterised in that** the at least one reflector (202) is configured to be removed from the plasma generation area (104).

91. Device according to one of Claims 55 to 91, **characterised in that** the device comprises one or more suction devices (208) to draw off gas from the plasma generation area (104).

92. Device according to one of Claims 55 to 91, **characterised in that** the device comprises at least one suction device (208) with at least one throttle valve (200) for varying the pressure in the plasma generation area (104).

93. Device according to one of Claims 55 to 92, **characterised in that** the device comprises an at least partially electrically insulating holder (212), by means of which the work piece (102) is electrically separated from the boundary walls of the plasma generation area (104).

94. Device according to one of Claims 55 to 93, **characterised in that** the work piece (102) is configured to be connected to a different electric potential from the electric potential of the boundary walls of the plasma generation area (104).

95. Device according to one of Claims 55 to 94, **characterised in that** the device comprises an electrically conductive holder (212), by means of which the work piece (102) is connected in an electrically conductive manner to the boundary walls of the plasma generation area (104).

96. Device according to one of Claims 55 to 95, **characterised in that** the work piece (102) is configured to be connected to the same electric potential as the boundary walls of the plasma generation area (104).

97. Device according to one of Claims 55 to 96, **characterised in that** the work piece (102) is configured to be connected to earth potential.

98. Device according to one of Claims 55 to 97, **characterised in that** the device is configured for curing a coating (100) on the work piece (102), which is curable by electromagnetic radiation, which comprises at least a uv radiation component, or by heat or by a combination of electromagnetic radiation, which comprises at least a uv radiation component, and heat.

99. Device according to one of Claims 55 to 98, **characterised in that** the device comprises a device for subjecting the work piece (102) before, during and/or after generation of the plasma to an electromagnetic radiation, which is not generated in the plasma, preferably to microwave radiation and/or to infrared radiation.

100. Device according to one of Claims 55 to 99, **characterised in that** the device comprises a device for drying the work piece (102) before, after and/or during generation of the plasma.

101. Device according to one of Claims 55 to 100, **characterised in that** the device comprises a device for subjecting the work piece (102) to a pressure lying below atmospheric pressure, preferably to a pressure in the range of approximately 2000 Pa to approximately 50 000 Pa, before generation of the plasma.

102. Device according to one of Claims 55 to 101, **characterised in that** the device comprises a device for subjecting the work piece (102), before generation of the plasma, to a pressure lying below atmospheric pressure, which is higher than the pressure, to which the work piece (102) is subjected during generation of the plasma.

103. Device according to one of Claims 55 to 102, **characterised in that** the device comprises a device for generating a magnetic field in the plasma generation area (104).

104. Device according to Claim 103, **characterised in that** the intensity of the magnetic field generated by the device for generating the magnetic field is configured to be varied during the curing process.

105. Device according to one of Claims 103 or 104, **characterised in that** generation of the magnetic field in the plasma generation area (104) is configured to be delayed in relation to the start of the curing process.

106. Device according to one of Claims 103 to 105, **characterised in that** the intensity of the magnetic field generated by the device for generating a magnetic field in the plasma generation area (104) is spatially variable.

## Revendications

1. Procédé de durcissement d'un revêtement (100) sur une pièce à usiner (102), **caractérisé en ce que** la pièce à usiner n'est pas planaire et qu'elle est dotée d'un revêtement (100) pouvant être durci par rayonnement électromagnétique, **en ce que** la pièce à usiner (102) est disposée dans une chambre de production de plasma (104), et **en ce que** du plasma est produit, dans la chambre de production de plasma (104), par introduction d'un rayon électromagnétique dans la chambre de production de plasma (104) au moyen d'au moins un dispositif d'introduction (132, 132'), plasma dans lequel un rayonnement électromagnétique adapté au durcissement du revêtement (100) est généré, rayonnement au moyen duquel le revêtement (100) est durci du moins en partie.

2. Procédé selon la revendication 1 **caractérisé par** la génération, dans le plasma, d'un rayonnement électromagnétique d'une longueur d'onde de l'ordre de 50 nm environ à 850 nm environ, en particulier de l'ordre de 50 nm environ à 700 nm environ, de préférence de l'ordre de 150 nm environ à 700 nm environ, de manière particulièrement préférée de l'ordre de 200 nm environ à 600 nm environ.

3. Procédé selon la revendication 2, **caractérisé en ce que** la pièce à usiner est dotée d'un revêtement (100) qui peut être durci par un rayonnement électromagnétique comprenant au moins une proportion de rayonnement UV.

4. Procédé selon l'une quelconque des revendications 1 à 3, **caractérisé en ce que** la pression dans la chambre de production de plasma (104) est réglée sur une valeur maximale d'environ 100 Pa, de préférence d'environ 1 Pa maximum, et en particulier d'environ 0,1 Pa maximum.

5. Procédé selon l'une quelconque des revendications 1 à 4, **caractérisé en ce que** la chambre de production de plasma (104) contient de l'azote et/ou un gaz rare, de préférence de l'argon, en tant que gaz de processus.

6. Procédé selon l'une quelconque des revendications 1 à 5, **caractérisé en ce que** la chambre de production de plasma (104) contient un gaz de processus auquel un additif est ajouté, par exemple un métal et/ou un halogénure métallique.

7. Procédé selon l'une quelconque des revendications 1 à 6, **caractérisé en ce que** le plasma est produit par introduction d'un rayonnement de micro-ondes, de préférence à une fréquence de l'ordre de 1 GHz environ à 10 GHz environ, en particulier de l'ordre de 2 GHz environ à 3 GHz environ.

8. Procédé selon l'une quelconque des revendications 6 ou 7, **caractérisé en ce que** le rayonnement électromagnétique est généré au moyen d'un magnétron (140).

9. Procédé selon l'une quelconque des revendications 6 à 8, **caractérisé en ce qu'**un champ magnétique est généré pour produire un effet RCE.

10. Procédé selon l'une quelconque des revendications 1 à 9, **caractérisé en ce que** le rayonnement électromagnétique est introduit dans la chambre de production de plasma (104) au moyen de plusieurs dispositifs d'introduction (132, 132').

11. Procédé selon l'une quelconque des revendications 1 à 10, **caractérisé en ce que** la pièce à usiner (102) présente un espace creux (152) ayant un orifice d'accès (154) et **en ce que** le rayonnement électromagnétique est introduit, au moyen d'au moins un dispositif d'introduction (132), dans la chambre de production de plasma (104) de manière à ce que le rayonnement électromagnétique arrive dans l'espace creux (152) de la pièce à usiner (102) par l'orifice d'accès (154).

12. Procédé selon l'une quelconque des revendications 1 à 11, **caractérisé en ce qu'**un gaz devant être ionisé est acheminé vers la chambre de production de plasma (104) pendant l'opération de durcissement.

13. Procédé selon la revendication 12, **caractérisé en ce que** le gaz devant être ionisé est acheminé vers la chambre de production de plasma (104) au moyen d'un dispositif d'introduction (144) situé au voisinage d'un dispositif d'introduction (132, 132') au moyen duquel un rayonnement électromagnétique est introduit dans la chambre de production de plasma (104).

14. Procédé selon l'une quelconque des revendications 1 à 13, **caractérisé en ce que** la pièce à usiner (102) est apportée dans une préchambre (160) et transférée, depuis la préchambre (160), dans la chambre de production de plasma (104) pour l'opération de durcissement.

15. Procédé selon la revendication 14, **caractérisé en ce que** l'air de la préchambre (160) est évacué après la mise en place de la pièce à usiner (102).

16. Procédé selon l'une quelconque des revendications 14 ou 15, **caractérisé en ce que** la pièce à usiner (102) est soumise, dans la préchambre (160), à un rayonnement électromagnétique, en particulier à un rayonnement de micro-ondes.

17. Procédé selon l'une quelconque des revendications 1 à 16, **caractérisé en ce que** la pièce à usiner (102) est transférée depuis la chambre de production de plasma (104) dans une chambre d'éclusage (162) après l'opération de durcissement.

18. Procédé selon la revendication 17, **caractérisé en ce que** l'air de la chambre d'éclusage (162) est évacué avant le transfert de la pièce à usiner (102) dans la chambre d'éclusage (162).

19. Procédé selon l'une quelconque des revendications 1 à 18, **caractérisé en ce que** la pièce à usiner (102) présente au moins une contre-dépouille et/ou au moins une zone cachée.

20. Procédé selon l'une quelconque des revendications 1 à 19, **caractérisé en ce que** la pièce à usiner (102) comprend un matériau électriquement conducteur.

21. Procédé selon l'une quelconque des revendications 1 à 20, **caractérisé en ce que** la pièce à usiner (102) comprend un matériau métallique.

22. Procédé selon l'une quelconque des revendications 1 à 21, **caractérisé en ce que** la pièce à usiner (102) comprend une matière plastique et/ou du bois.

23. Procédé selon l'une quelconque des revendications 1 à 22, **caractérisé en ce que** la chambre de production de plasma (104) contient de l'azote, de l'hélium et/ou de l'argon en tant que gaz de processus.

24. Procédé selon l'une quelconque des revendications 1 à 23, **caractérisé en ce que** la chambre de production de plasma (104) contient un gaz de processus dont la composition varie pendant l'opération de durcissement.

25. Procédé selon la revendication 24, **caractérisé en ce que** la composition du gaz de processus varie de telle manière que le centre de gravité du rayonnement électromagnétique généré dans le plasma pendant l'opération de durcissement se situe à une première longueur d'onde pendant une première phase de l'opération de durcissement et à une deuxième longueur d'onde pendant une deuxième phase ultérieure de l'opération de durcissement, la deuxième longueur d'onde étant différente de la première longueur d'onde.

26. Procédé selon la revendication 25, **caractérisée en ce que** la deuxième longueur d'onde est inférieure à la première longueur d'onde.

27. Procédé selon l'une quelconque des revendications 24 à 26, **caractérisé en ce que** la composition du gaz de processus varie de telle manière que le centre de gravité du rayonnement électromagnétique généré dans le plasma pendant l'opération de durcissement se décale vers des longueurs d'onde plus petites au fur et à mesure que la durée de durcissement augmente.

28. Procédé selon l'une quelconque des revendications 1 à 27, **caractérisé en ce que** la chambre de production de plasma (104) contient de l'argon, de préférence, pour l'essentiel, exclusivement de l'argon, au moment où le plasma est allumé.

29. Procédé selon l'une quelconque des revendications 1 à 28, **caractérisé en ce qu'**un ou plusieurs gaz et/ou un mélange gazeux est/sont acheminé(s) vers la chambre de production de plasma (104) par l'intermédiaire d'un ou plusieurs dispositifs d'alimentation (144).

30. Procédé selon l'une quelconque des revendications 1 à 29, **caractérisé en ce que** le plasma est produit par introduction d'un rayonnement électromagnétique dans la chambre de production de plasma (104) au moyen de plusieurs dispositifs d'introduction (132, 132'), au moins deux des dispositifs d'introduction (132, 132') présentant des performances d'introduction différentes les unes des autres.

31. Procédé selon l'une quelconque des revendications 1 à 30, **caractérisé en ce que** le plasma est produit par introduction d'un rayonnement électromagnétique dans la chambre de production de plasma (104) au moyen de plusieurs dispositifs d'introduction (132, 132'), au moins deux des dispositifs d'introduction (132, 132') étant de type différent.

32. Procédé selon l'une quelconque des revendications 1 à 31, **caractérisé en ce que** la chambre de production de plasma (104) contient au moins un réflecteur (202) destiné à réfléchir le rayonnement électromagnétique généré dans le plasma.

33. Procédé selon la revendication 32, **caractérisé en ce que** la chambre de production de plasma (104) contient au moins un film réfléchissant en tant que réflecteur (202).

34. Procédé selon l'une quelconque des revendications 32 ou 33, **caractérisé en ce qu'**au moins une zone partielle des murs de délimitation de la chambre de production de plasma (104) est conçue en tant que réflecteur (202).

35. Procédé selon l'une quelconque des revendications 32 à 34, **caractérisé en ce que** l'au moins un réflecteur (202) comprend de l'aluminium et/ou de l'acier inoxydable en tant que matériau réfléchissant.

36. Procédé selon l'une quelconque des revendications 32 à 35, **caractérisé en ce que** l'au moins un réflecteur (202) peut être retiré de la chambre de production de plasma (104).

37. Procédé selon l'une quelconque des revendications 1 à 36, **caractérisé en ce que** du gaz est aspiré hors de la chambre de production de plasma (104) par l'intermédiaire d'un ou plusieurs dispositifs d'aspiration (208).

38. Procédé selon l'une quelconque des revendications 1 à 37, **caractérisé en ce qu'**on fait varier la pression dans la chambre de production de plasma (104) au moyen d'au moins un dispositif d'aspiration (208) avec un clapet d'étranglement (200).

39. Procédé selon l'une quelconque des revendications 1 à 38, **caractérisé en ce que** la pièce à usiner (102) est séparée électriquement des murs de délimitation de la chambre de production de plasma (104) au moyen d'une attache (212) au moins en partie électriquement isolante.

40. Procédé selon l'une quelconque des revendications 1 à 39 **caractérisé en ce que** la pièce à usiner (102) est posée sur un potentiel électrique différent du potentiel électrique des murs de délimitation de la chambre de production de plasma (104).

41. Procédé selon l'une quelconque des revendications 1 à 40, **caractérisé en ce que** la pièce à usiner (102) est reliée de manière électriquement conductrice aux murs de délimitation de la chambre de production de plasma (104) au moyen d'une attache électrique conductrice.

42. Procédé selon l'une quelconque des revendications 1 à 41, **caractérisé en ce que** la pièce à usiner (102) est posée sur le même potentiel électrique que les murs de délimitation de la chambre de production de plasma (104).

43. Procédé selon l'une quelconque des revendications 1 à 42, **caractérisé en ce que** la pièce à usiner (102) est posée sur un potentiel de masse.

44. Procédé selon l'une quelconque des revendications 1 à 43, **caractérisé en ce que** la pièce à usiner (102) est dotée d'un revêtement (100) qui peut être durci par rayonnement électromagnétique, qui comprend au moins une fraction de rayonnement UV, ou par la chaleur ou par une combinaison de rayonnement électromagnétique, qui comprend au moins une fraction de rayonnement UV, et de chaleur.

45. Procédé selon l'une quelconque des revendications 1 à 44, **caractérisé en ce que** la pièce à usiner (102) est exposée, avant, pendant et/ou après la production du plasma, à un rayonnement électromagnétique qui n'est pas généré dans le plasma.

46. Procédé selon la revendication 45, **caractérisé en ce que** la pièce à usiner (102) est exposée, avant, pendant et/ou après la production de plasma, à un rayonnement de micro-ondes et/ou un rayonnement infrarouge qui n'est pas généré dans le plasma.

47. Procédé selon l'une quelconque des revendications 1 à 45, **caractérisé en ce que** la pièce à usiner (102) est séchée avant, après et/ou pendant la production de plasma.

48. Procédé selon l'une quelconque des revendications 1 à 47, **caractérisé en ce que** la pièce à usiner (102) est exposée, avant la production du plasma, à une pression inférieure à la pression atmosphérique, de préférence à une pression de l'ordre de 2000 Pa environ à 50000 Pa environ.

49. Procédé selon l'une quelconque des revendications 1 à 48, **caractérisé en ce que** la pièce à usiner (102) est exposée, avant la production du plasma, à une pression inférieure à la pression atmosphérique et supérieure à la pression à laquelle est exposée la pièce à usiner (102) pendant la production du plasma.

50. Procédé selon l'une quelconque des revendications 1 à 49, **caractérisé en ce qu'**un champ magnétique est généré dans la chambre de production de plasma (104).

51. Procédé selon la revendication 50, **caractérisée en ce qu'**on fait varier la force du champ magnétique pendant l'opération de durcissement.

52. Procédé selon l'une quelconque des revendications 50 ou 51, **caractérisé en ce que** le champ magnétique est généré, dans la chambre de production de plasma (104) uniquement après le début de l'opération de durcissement.

53. Procédé selon l'une quelconque des revendications 50 à 52, **caractérisé en ce que** la force du champ magnétique varie dans l'espace dans la chambre de production de plasma (104).

54. Carrosserie de véhicule dotée d'un revêtement (100) dans un espace intérieur de la carrosserie de véhicule (164) qui a été durcie avec le procédé selon l'une quelconque des revendications 1 à 53.

55. Dispositif de durcissement d'un revêtement (100), pouvant être durci par rayonnement électromagnétique sur une pièce à usiner (102), **caractérisé en ce que** le dispositif (122) comprend une chambre de production de plasma (104), un dispositif (170) destiné à la mise en place de la pièce à usiner (102) dans la chambre de production de plasma (104) et un dispositif (132, 132', 136, 140) de production d'un plasma dans la chambre de production de plasma (104), un rayonnement électromagnétique adapté au durcissement du revêtement (100) sur la pièce à usiner (102) pouvant être généré dans le plasma et le revêtement (100) durci, du moins en partie, au moyen de ce rayonnement électromagnétique et **en ce que** le dispositif (122) comprend au moins un dispositif d'introduction (132, 132') pour l'introduction d'un rayonnement électromagnétique dans la chambre de production de plasma (104), au moins un dispositif d'introduction (132') étant disposé et orienté de manière que le rayonnement électromagnétique, introduit dans la chambre de production de plasma (104) au moyen de ce dispositif d'introduction (132'), arrive, au travers d'un orifice d'accès (154), dans un espace creux (152) de la pièce à usiner (102) disposée dans la chambre de production de plasma (104).

56. Dispositif selon la revendication 55, **caractérisé en ce que**, dans la chambre de production de plasma (104), un plasma peut être produit qui émet un rayonnement électromagnétique d'une longueur d'onde de l'ordre de 50 nm environ à 850 nm environ, en particulier de l'ordre de 50 nm environ à 700 nm environ, de préférence de l'ordre de 150 nm environ à 700 nm environ, de manière particulièrement préférée de l'ordre d'environ 200 nm environ à 600 nm environ.

57. Dispositif selon l'une quelconque des revendications 55 ou 56, **caractérisé en ce que** la pression d'un gaz de processus dans la chambre de production de plasma (104) peut être réglée sur une valeur d'environ 100 Pa maximum, de préférence d'environ 1 Pa maximum, en particulier d'environ 0,1 Pa maximum.

58. Dispositif selon l'une quelconque des revendications 55 à 57, **caractérisé en ce que** la chambre de production de plasma (104) contient de l'azote ou un gaz rare, de préférence de l'argon, en tant que gaz de processus.

59. Dispositif selon l'une quelconque des revendications 55 à 58, **caractérisé en ce qu'**un rayonnement de micro-ondes, de préférence d'une fréquence de l'ordre d'environ 1 GHz à environ 10 GHz, en particulier de l'ordre d'environ 2 GHz à environ 3 GHz, peut être introduit dans la chambre de production de plasma (104) au moyen du dispositif d'introduction (132, 132').

60. Dispositif selon l'une quelconque des revendications 55 à 59, **caractérisé en ce que** le dispositif (122) comprend un dispositif (140) destiné à la génération d'un rayonnement électromagnétique.

61. Dispositif selon l'une quelconque des revendications 55 à 60, **caractérisé en ce que** le dispositif (122) comprend un dispositif (138) destiné à la production d'un champ magnétique dans la chambre de production de plasma (104).

62. Dispositif selon l'une quelconque des revendications 55 à 61, **caractérisé en ce que** le dispositif (122) comprend plusieurs dispositifs d'introduction (132, 132') destinés à l'introduction d'un rayonnement électromagnétique dans la chambre de production de plasma (104).

63. Dispositif selon l'une quelconque des revendications 55 à 62, **caractérisé en ce que** le dispositif (122) comprend au moins un dispositif d'alimentation (144) pour l'acheminement d'un gaz devant être ionisé vers la chambre de production de plasma (104).

64. Dispositif selon la revendication 63, **caractérisé en ce que** le dispositif d'alimentation (144) est disposé au voisinage d'un dispositif d'introduction (132, 132') au moyen duquel un rayonnement électromagnétique peut être introduit dans la chambre de production de plasma (104).

65. Dispositif selon l'une quelconque des revendications 55 à 64, **caractérisé en ce que** le dispositif (122) comprend une préchambre (160) destinée à recevoir la pièce à usiner (102) avant l'opération de durcissement.

66. Dispositif selon la revendication 65, **caractérisé en ce que** la préchambre (160) peut être évacuée.

67. Dispositif selon l'une quelconque des revendications 65 ou 66, **caractérisé en ce que** la préchambre (160) est dotée d'un dispositif (132, 136, 140) destiné à exposer la pièce à usiner (102), dans la préchambre (160), à un rayonnement électromagnétique, en particulier à un rayonnement de micro-ondes.

68. Dispositif selon l'une quelconque des revendications 65 à 67, **caractérisé en ce que** le dispositif (122) comprend un dispositif de convoyage (170), de préférence un convoyeur à galets (170), pour convoyer la pièce à usiner (102) depuis la préchambre (160) dans la chambre de production de plasma (104).

69. Dispositif selon l'une quelconque des revendications 55 à 68, **caractérisé en ce que** le dispositif (122) comprend une chambre d'éclusage (162) destinée à recevoir la pièce à usiner (102) après l'opération de durcissement.

70. Dispositif selon la revendication 69, **caractérisé en ce que** l'air de la chambre d'éclusage (162) peut être évacué.

71. Dispositif selon l'une quelconque des revendications 69 ou 70, **caractérisé en ce que** le dispositif (122) comprend un dispositif de convoyage (170), de préférence un convoyeur à galets, pour convoyer la pièce à usiner (102) depuis la chambre de production de plasma (104) dans la chambre d'éclusage (162).

72. Dispositif selon l'une quelconque des revendications 55 à 71, **caractérisé en ce que** le dispositif de durcissement d'un revêtement (100) est aménagé sur une pièce à usiner (102) non planaire.

73. Dispositif selon l'une quelconque des revendications 55 à 72, **caractérisé en ce qu'**il est conçu pour le durcissement d'un revêtement (100) sur une pièce à usiner (102) qui présente au moins une contre-dépouille et/ou au moins une zone cachée.

74. Dispositif selon l'une quelconque des revendications 55 à 73, **caractérisé en ce qu'**il est conçu pour le durcissement d'un revêtement (100) sur une pièce à usiner (102) qui comprend un matériau électriquement conducteur.

75. Dispositif selon l'une quelconque des revendications 55 à 74, **caractérisé en ce qu'**il est conçu pour le durcissement d'un revêtement (100) sur une pièce à usiner (102) qui comprend un matériau métallique.

76. Dispositif selon l'une quelconque des revendications 55 à 75, **caractérisé en ce qu'**il est conçu pour le durcissement d'un revêtement (100) sur une pièce à usiner (102) qui comprend un matériau plastique et/ou du bois.

77. Dispositif selon l'une quelconque des revendications 55 à 76, **caractérisé en ce que** de l'azote, de l'hélium et/ou de l'argon, en tant que gaz de processus, peut être acheminé vers la chambre de production de plasma (104).

78. Dispositif selon l'une quelconque des revendications 55 à 77, **caractérisé en ce que** la chambre de production de plasma (104) contient un gaz de processus dont la composition varie pendant l'opération de durcissement.

79. Dispositif selon la revendication 78, **caractérisé en ce que** la composition du gaz de processus varie de telle manière que le centre de gravité du rayonnement électromagnétique généré dans le plasma pendant l'opération de durcissement se situe à une première longueur d'onde pendant une phase de l'opération de durcissement et à une deuxième longueur d'onde pendant une deuxième phase ultérieure de l'opération de durcissement, la deuxième longueur d'onde étant différente de la première longueur d'onde.

80. Dispositif selon la revendication 79, **caractérisé en ce que** la deuxième longueur d'onde est inférieure à la première longueur d'onde.

81. Dispositif selon l'une quelconque des revendications 78 à 80, **caractérisé en ce qu'**on peut faire varier la composition du gaz de processus dans la chambre de production de plasma (104) de manière que le centre de gravité du rayonnement électromagnétique généré dans le plasma pendant l'opération de durcissement se décale vers des longueurs d'ondes plus petites au fur et à mesure que la durée de durcissement augmente.

82. Dispositif selon l'une quelconque des revendications 55 à 81, **caractérisé en ce que** la chambre de production de plasma (104) contient de l'argon, de préférence, pour l'essentiel, exclusivement de l'argon, au moment où le plasma est allumé.

83. Dispositif selon l'une quelconque des revendications 55 à 82, **caractérisé par** un ou plusieurs dispositifs d'alimentation (144) au moyen desquels un ou plusieurs gaz et/ou un mélange gazeux peut/peuvent être acheminé(s) vers la chambre de production de plasma (104).

84. Dispositif selon l'une quelconque des revendications 55 à 83, **caractérisé par** plusieurs dispositifs d'introduction (132, 132') destinés à la production de plasma par introduction d'un rayonnement électromagnétique dans la chambre de production de plasma (104), au moins deux des dispositifs d'introduction (132, 132') ayant des performances d'introduction différentes l'une de l'autre.

85. Dispositif selon l'une quelconque des revendications 55 à 84, **caractérisé par** plusieurs dispositifs d'introduction (132, 132') destinés à la production de plasma par introduction d'un rayonnement électromagnétique dans la chambre de production de plasma (104), au moins deux des dispositifs d'introduction (132, 132') étant de type différent.

86. Dispositif selon l'une quelconque des revendications 55 à 85, **caractérisé en ce que** la chambre de production de plasma (104) contient au moins un réflecteur (202) pour réfléchir le rayonnement électromagnétique généré dans le plasma.

87. Dispositif selon l'une quelconque la revendication 86, **caractérisé en ce que** la chambre de production de plasma (104) contient au moins un film réfléchissant en tant que réflecteur.

88. Dispositif selon l'une quelconque des revendications 86 ou 87, **caractérisé en ce qu'**au moins une zone partielle des murs de délimitation de la chambre de production de plasma (104) est conçue en tant que réflecteur (202).

89. Dispositif selon l'une quelconque des revendications 86 à 88, **caractérisé en ce que** l'au moins un réflecteur (202) comprend de l'aluminium et/ou de l'acier inoxydable en tant que matériau réfléchissant.

90. Dispositif selon l'une quelconque des revendications 86 à 89, **caractérisé en ce que** l'au moins un réflecteur (202) peut être retiré de la chambre de production de plasma (104).

91. Dispositif selon l'une quelconque des revendications 55 à 90, **caractérisé en ce que** le dispositif comprend un ou plusieurs dispositifs d'aspiration (208) pour aspirer le gaz de la chambre de production de plasma (104).

92. Dispositif selon l'une quelconque des revendications 55 à 91, **caractérisé en ce que** le dispositif comprend au moins un dispositif d'aspiration (208) muni d'au moins un clapet d'étranglement (200) pour faire varier la pression dans la chambre de production de plasma (104).

93. Dispositif selon l'une quelconque des revendications 55 à 92, **caractérisé en ce que** le dispositif comprend une attache (212) au moins en partie électriquement isolante au moyen de laquelle la pièce à usiner (102) est séparée électriquement des murs de délimitation de la chambre de production de plasma (104).

94. Dispositif selon l'une quelconque des revendications 55 à 93, **caractérisé en ce que** la pièce à usiner (102) peut être déposée sur un potentiel électrique différent du potentiel électrique des murs de délimitation de la chambre de production de plasma (104).

95. Dispositif selon l'une quelconque des revendications 55 à 94, **caractérisé par** une attache électriquement conductrice (212), au moyen de laquelle la pièce à usiner (102) est reliée, de façon électriquement conductrice, aux murs de délimitation de la chambre de production de plasma (104).

96. Dispositif selon l'une quelconque des revendications 55 à 95, **caractérisé en ce que** la pièce à usiner (102) peut être déposée sur le même potentiel électrique que les murs de délimitation de la chambre de production de plasma (104).

97. Dispositif selon l'une quelconque des revendications 55 à 96, **caractérisé en ce que** la pièce à usiner (102) peut être déposée sur un potentiel de masse.

98. Dispositif selon l'une quelconque des revendications 55 à 97, **caractérisé en ce qu'**il est conçu pour le durcissement d'un revêtement (100) sur une pièce à usiner (102) qui peut être durcie par rayonnement électromagnétique, qui comprend au moins une fraction de rayonnement UV, ou par la chaleur ou par une combinaison de rayonnement électromagnétique, qui comprend au moins une fraction de rayonnement UV, et de chaleur.

99. Dispositif selon l'une quelconque des revendications 55 à 98, **caractérisé en ce qu'**il comprend un dispositif pour exposer la pièce à usiner (102) avant, pendant et/ou après la production de plasma, à un rayonnement électromagnétique qui n'est pas généré dans le plasma, de préférence à un rayonnement de micro-ondes et/ou un rayonnement infrarouge.

100. Dispositif selon l'une quelconque des revendications 55 à 99, **caractérisé en ce qu'**il comprend un dispositif pour sécher la pièce à usiner (102) avant, pendant et/ou après la production de plasma.

101. Dispositif selon l'une quelconque des revendications 55 à 100, **caractérisé en ce qu'**il comprend un dispositif pour exposer la pièce à usiner (102), avant la production du plasma, à une pression inférieure à la pression atmosphérique, de préférence à une pression de l'ordre de 2000 Pa environ à 50000 Pa environ.

102. Dispositif selon l'une quelconque des revendications 55 à 101, **caractérisé en ce qu'**il comprend un dispositif pour exposer la pièce à usiner (102), avant la production du plasma, à une pression inférieure à la pression atmosphérique et supérieure à la pression à laquelle est exposée la pièce à usiner (102) pendant la production du plasma.

103. Dispositif selon l'une quelconque des revendications 55 à 102, **caractérisé en ce qu'**il comprend un dispositif pour générer un champ magnétique dans la chambre de production de plasma (104).

104. Dispositif selon la revendication 103, **caractérisé en ce qu'**on peut faire varier la force du champ magnétique généré par le dispositif de génération du champ magnétique pendant l'opération de durcissement.

105. Dispositif selon l'une quelconque des revendications 103 ou 104, **caractérisé en ce que** la génération du champ magnétique dans la chambre de production de plasma (104) peut être retardée par rapport au début de l'opération de durcissement.

106. Dispositif selon l'une quelconque des revendications 103 à 105, **caractérisé en ce que** la force du champ magnétique généré au moyen du dispositif de génération d'un champ magnétique dans la chambre de production de plasma (104) est variable dans l'espace.
